# EUROPEAN PATENT SPECIFICATION

(11) **EP 2 912 685 B1**
(45) Date of publication and mention of the grant of the patent: **08.04.2020**
(21) Application number: 13793010.3
(22) Date of filing: 25.10.2013
(51) Int. Cl.: H01L 21/762

(54) **SEMICONDUCTOR DEVICES WITH IMPROVED RELIABILITY AND OPERATING LIFE AND METHODS OF MANUFACTURING THE SAME**
HALBLEITERBAUELEMENTE MIT VERBESSERTER ZUVERLÄSSIGKEIT UND GEBRAUCHSDAUER UND VERFAHREN ZUR HERSTELLUNG DAVON
DISPOSITIF À SEMI-CONDUCTEURS À FIABILITÉ ET DURÉE DE VIE AMÉLIORÉES ET LEURS PROCÉDÉS DE FABRICATION

(30) Priority: 26.10.2012 US 201261719201 P
(43) Date of publication of application: 02.09.2015
(73) Proprietor: RFHIC Corporation, Dongan-gu Anyang-si, Gyeonggi-do 14055 (KR)
(72) Inventor: FRANCIS, Daniel, Santa Clara, CA 95054 (US); BABIC, Dubravko, Santa Clara, CA 95054 (US); NASSER-FAILI, Firooz, Santa Clara, CA 95054 (US); EJECKAM, Felix, Santa Clara, CA 95054 (US); DIDUCK, Quentin, Santa Clara, CA 95054 (US); SMART, Joseph, Santa Clara, CA 95054 (US); MATTHEWS, Kristopher, Santa Clara, CA 95054 (US); LOWE, Frank, Santa Clara, CA 95054 (US)
(74) Representative: Haseltine Lake Kempner LLP
(86) International application number: PCT/US2013/066778
(87) International publication number: WO 2014/066740

(56) References cited:
- US-A1- 2004 005 740
- US-A1- 2007 105 256
- US-A1- 2009 278 233

## Description

### FIELD OF THE INVENTION

The present invention relates manufacturing of engineered wafers which are used to build electronic and optoelectronic devices with improved reliability and operating life. Certain embodiments particularly relate to methods for fabricating gallium nitride (GaN) on substrate engineered wafers for building high-electron mobility transistors, radio-frequency (RF) electronic devices, light-emitting-diodes, and lasers.

The following terminology is commonly used in this field of technology and these definitions may be useful for interpreting this specification:
Wide-gap semiconductor technology may be used to refer to electronic and optoelectronic devices and manufacturing technology based on wide-gap semiconductors.

Single-crystal material, wafer, or layer may be used to refer to materials, wafers, or layers formed of one crystal, namely, having a translational symmetry. This term is common for crystal growth, and is a requirement for most semiconductors. Real semiconductors have defects, but the defect densities are sufficiently low that assuming translational symmetry explains electronic and optical properties of these materials.

Polycrystalline material may be used to refer to a material consisting of crystals variously oriented or composed of more than one crystal.

Amorphous material may be used to refer to a material having no real or apparent crystalline form.

Synthetic diamond may be used to refer to man-made diamond produced by any one of the methods known in the art including, but not limited to, high-temperature high-pressure techniques and chemical vapor deposition (CVD).

Bonding or wafer bonding may be used to refer to a technology in which two surfaces, commonly semiconductor surfaces, are brought into proximity and are caused to adhere firmly. The bonding can be achieved by chemical bonding or using an adhesive. This process is commonly used in semiconductor technology. See, for example, the book by Tong and Gosele entitled Semiconductor Wafer Bonding, Springer Verlag, 1989.

### BACKGROUND OF THE INVENTION

Device reliability is the final obstacle and duty of the manufacturer to realize prior to shipping and getting acceptance of his/her commercial devices in the field. GaN devices (e.g. high-electron mobility transistors and light-emitting devices) have been a particular subject of reliability studies in recent years. Origins of device failure are found in both starting material quality and device processing. High-reliability device manufacturing practices include careful choice of materials and processing recipes that are known or have been proven to result in durable electronic or optoelectronic devices. Material quality affects device performance through the existence of defects embedded into crystalline material at the time of growth or substrate manufacture and can move gradually towards an interface or surface during device operation at elevated temperature. Device degradation due to dislocations propagating from strained and dislocated epilayers (epitaxially grown layers) below the device is a particular problem with devices in which the active epilayers (semiconductors) were grown on substrates that have a different lattice constant. In such epilayer structures, additional layers, commonly referred to as nucleation layers, transition layers, strain-compensating layers, or strain-matching layers are disposed between the substrate of one lattice constant and the active epilayers that exhibit a lattice constant different from the substrate. Examples include GaN-based light-emitting diodes and high-electron mobility transistors that are both grown on sapphire, silicon, or silicon carbide substrates, all of which have a lattice constant different from GaN. See Table 1 below for examples of lattice constants of common GaN growth substrates.

**Table 1 - Lattice constants for hexagonal GaN and common substrates. Lattice mismatch is calculated as (a_{GaN}-a_{sub})/a_{sub}. (FCC = Face-Centered Cubic, HEX = Hexagonal)**

| | Crystal structure | *a* [nm] | *c* [nm] | GaN Lattice mismatch [%] |
|---|---|---|---|---|
| GaN (0001) | HEX | 0.319 | 0.518 | - |
| 4H-SiC (0001) | HEX | 0.307 | 1.005 | +3.4 % |
| 6H-SiC (0001) | HEX | 0.307 | 1.511 | +3.4 % |
| Si (111) | FCC | 0.543 | | +20 % |
| Diamond (111) | FCC | 0.357 | | +27 % |
| Al₂O₃ (0001) | HEX | 0.479 | 1.299 | -13.6 % |
| AlN (0001) | HEX | 0.311 | 0.498 | 2.5 % |

Lattice or crystal structure is a unique arrangement of atoms or molecules in a crystalline liquid or solid. A crystal structure is composed of a pattern defining the way atoms or molecules are arranged relative to each other exhibiting a long range order and symmetry. Patterns are defined by points on a crystal lattice, which is an array of points repeating periodically in three dimensions. Lattice mismatch is defined as the relative difference between the lattice constants of two materials, both materials being crystalline. In general, lattice mismatch will prevent growth of a defect-free epitaxial film of lattice constant *x*₁ different from the lattice constant *x*₂ of the underlying crystal (or substrate) unless the thickness of the epitaxial film is below a certain critical thickness. If the epitaxial film is thin, the lattice mismatch can be compensated by strain in the film. More specifically, the energy required to strain the epitaxial film is lower than the energy required for growing a dislocated epitaxial film. Since the energy required to strain the epitaxial film grows with the epitaxial film thickness, at some thickness, referred to as the critical thickness, the growth starts including dislocations into the film. The active regions of field-effect transistors and light-emitting devices require more than several hundred nanometers or in some cases more than several micrometers in thickness. This means that the active semiconductor layers of such devices need to be grown on a template or a substrate that has a very close lattice parameters to be dislocation free as is well known in the art of epitaxial growth.

Cubic crystals, such as GaAs, InP, silicon, and diamond have only one lattice constant, but hexagonal crystals, such as silicon carbide, gallium nitride, and related compounds have two lattice constants: *a* in the basal plane; and c perpendicular to the basal plane. Most GaN-based growth on hexagonal substrates listed in Table 1 is done on the basal plane because the crystal lattice matches to GaN and the basal lattice constant is close to GaN. Hence GaN can be grown on different polymorphs of silicon carbide (4H or 6H). Lattice mismatch in this case is defined as (*a*_{GaN} - *a*_{sub})/*a*_{sub} and expressed in percentage, where *a*_{GaN} and *a*_{sub} are basal lattice constants and the subscript "sub" refers to the lattice constant of the substrate or the layer on top of which GaN is grown. Growing hexagonal GaN on silicon which has a cubic crystal lattice is done on a (111) plane of silicon because in this direction, the lattice appears hexagonal and the basal lattice constant is closer to GaN.

The ultimate lattice mismatch that GaN epilayers experience on top of a substrate is also determined by the thermal expansion coefficient of the two materials (GaN and the substrate) because the crystal forms at elevated temperatures (>1000°C) and its lattice constant reduces once it cools to room temperature, the reduction being dependent on the coefficient of thermal expansion of the materials. Lattice mismatch causes defects in the grown layers, while thermal expansion introduces strain in the layers during cooling after epitaxial growth. Compositional variations also introduce strain because in most cases different compositions have different lattice constants.

GaN is presently grown on a variety of different substrates listed in Table 1 including sapphire, silicon, silicon carbide, aluminum nitride, single-crystal diamond, and GaN substrates. With the exception of GaN substrates, all materials have lattice constants that differ from that of GaN. All the examples listed in Table 1 are wafers made out of single crystal and can be described with crystal structure and lattice constants. In order to epitaxially grow high-quality AlGaN alloys on top of substrates with lattice constants different from GaN or AlGaN alloy, it has been common practice to grow a layer or a combination of layers, referred to as nucleation, transition, strain-matching, and/or strain-compensating layers, on top of the lattice-mismatched substrate in order to terminate the dislocations and absorb the strain accumulated by growing on a substrate with a different lattice constant. The goal is to produce a low-dislocation density epilayer on top of which growth of high-quality active layers is possible.

The requirement on how low the dislocation density has to be is determined by the type of the electronic or optoelectronic device to be fabricated and its performance. The exact structure of the nucleation layers differs from manufacturer to manufacturer. Nucleation layer or layers generally refers to one or more layers of different composition and thickness required to transition from the lattice constant of the substrate to the GaN epilayer. An active layer structure can be grown on top of the transition layers. The active layers and resulting devices may be high-frequency transistors and/or optoelectronic devices such as laser diodes, light-emitting diodes, and super-luminescent diodes. Nucleation layers can include any number of binary or ternary epitaxial layers followed by a suitably thick gallium-nitride buffer added for distancing the active layers from the nucleation layers and achieving low dislocation density. In GaN-based growth, the nucleation layers typically include layers made with the AlGaN and/or AlN alloys.

The purpose of the GaN buffer is two-fold: (i) it distances the active layers from the nucleation layers; and (ii) it provides the low-gap side of the AlGaN/GaN heterojunction in forming a two-dimensional electron gas (2DEG). The thickness of the GaN buffer is dictated by the desired breakdown voltage, the necessity of distancing the active layer from any charges in or at the interface with the nucleation layer, and by the requirement for low dislocation density as thicker GaN buffer layers allow sufficient amount of vertical space for terminating the dislocations originating at the transition layers. Typical dislocation densities in GaN devices on silicon, silicon carbide, and sapphire epilayer-wafers for use in field-effect applications can be between 1E8 1/cm² and 1E9 1/cm². Defect densities required for efficient operation of bipolar devices, such as bipolar transistors and optoelectronic devices, range from 1E6 1/cm² to 1E8 1/cm².

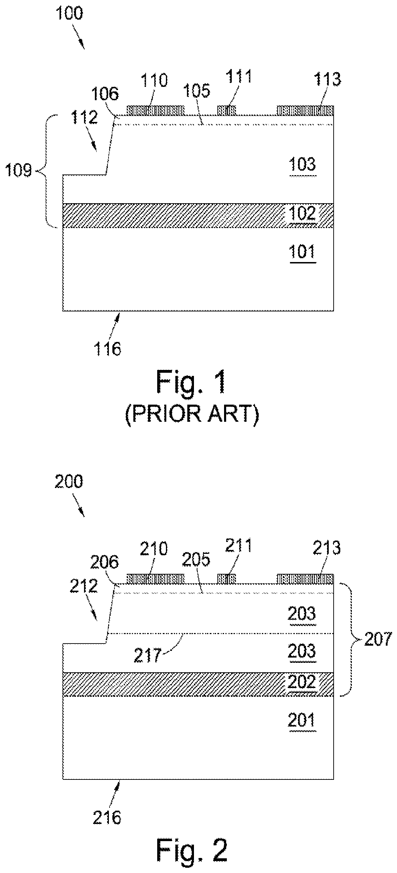

A typical epilayer structure for a AlGaN/GaN high-electron mobility transistor (HEMT) 100 is shown in Figure 1 and comprises a native growth substrate 101 on top of which are deposited nucleation/transition layers 102, a GaN buffer 103, and an AlGaN barrier 106. The heterojunction between the barrier layer 106 and the GaN buffer 103 accumulates electrons and forms a two-dimensional electron gas (2DEG) 105. Individual devices are isolated from each other by either etching trenches 112 or implantation (not shown).

The method of manufacture of the epilayer structure illustrated in Figure 1 is well known in the art. It starts by first forming the nucleation layers 102 on top of the native substrate 101 to adapt the lattice constant to GaN (or a related alloy), and then growing a sufficient thickness of the GaN buffer 103 before the AlGaN barrier 106 is grown. The region of the GaN buffer 103 closest to the AlGaN barrier 106 may also include an under-channel barrier (not shown) or other specific features that improve the performance of such field-effect transistors and is known in the art.

The epitaxially grown stack 109 accomplishes two functions: (i) nucleation of the GaN epilayers; and (ii) the electronic/optoelectronic device function. Once the epitaxial growth is complete, the wafer is processed using standard semiconductor techniques to define electronic devices, in this case a field-effect transistor, by depositing metals to form ohmic contacts for the source 110 and the drain 113 terminals and a Schottky contact to form the gate 111 terminal. Field-effect transistor 100 chips are packaged by either flip-chip or by soldering the back 110 of the substrate 101 to a package base (not shown). The operation of this transistor, and device enhancements described above, have been described in publicly available literature, such as, books by Rűdiger Quay entitled "Gallium Nitride Electronics", and Umesh K. Mishra and J. Singh entitled "Semiconductor Device Physics and Design", both books published by Springer in 2008.

The lifetime of electronic devices is determined by a number of different phenomena some of which depend on the geometry of the contacts and Schottky barrier and the materials used, while some depend on the specific characteristics of the epilayers and associated materials of which the device is made. The presence of a lattice-mismatched native substrate and the formation of dislocations and other defects as a result of stress resulting from the use of a lattice-mismatched native substrate fall into the latter group of physical properties that affect reliability. As AlGaN/GaN high-electron mobility transistors are grown on lattice-mismatched native substrates, it is not possible to eliminate this problem. This problem persist in all other types of electronic and optoelectronic devices that are made in semiconductors grown on lattice-mismatched substrates.

In light of problems such as those described above, a number of suggestions have been made in the art for alleviating some of the problems associated with semiconductor device reliability. Some examples are given below.

US 8,222,135 discloses the use of A1N to improve the reliability of copper-based metallization. US 7,985,687 discloses a semiconductor-device processing methodology for realizing high reliability. US 7,655,555 discloses a process for realizing high reliability devices. US RE40,339 discloses a process for forming an isolation barrier in a semiconductor device to prevent diffusion of impurities and thereby forming a high reliability device. US 6,281,095 also discloses forming an isolation layer. US 7,372,165 discloses a process for making high reliability conductive paths using cross-diffusion of metal. US 7,338,826 discloses a process for improving the reliability of AlGaN/GaN HEMTs by performing surface treatment using ammonia. US 6,984,875 discloses using a modified layer between a conducting and isolating layer on a substrate to form devices with improved reliability. US 5,960,275 discloses a method for manufacturing power MOSFETs to achieve high reliability. US 7,161,242 discloses a method for forming a high reliability device using a base material that is different from a substrate material. US 7,105,920 discloses a method for modifying a substrate to achieve high-reliability packaging of semiconductor devices. US 6,635,941 discloses a method for forming devices with improved reliability by bonding two substrates together. US 6,002,172 discloses a method for modifying a substrate for attaching to a package. US 8,058,163 discloses a method for improving solder joints between the chip and the substrate in chips packaged by dielectric encasement.

US 5,650,639 by Schrantz, et al.*,* discloses bonding of epitaxial layers with diamond substrates for the purpose of improving thermal performance. US 7,033,912 Saxler teaches growing diamond on thinned silicon carbide substrates and optionally growing active layers on this structure. US 6,794,276 Letertre, et al*.* teaches creation of new substrates for semiconductor devices. US 7,358,152 by Kub and Hobart discloses a number of methods for improving the heat conductance of electronic devices, specifically GaN HEMTs, using wafer bonding of either completed devices or blank GaN epiwafers to highly thermally conductive substrates, synthetic diamond included. US 2007/105256 A1 discloses the forming of a semiconductor structure. US 2009/278233 A1 teaches a method for manufacturing a wafer-bonded semiconductor structure.

While a multitude of suggestions have been made for improving semiconductor device reliability, the only apparent means for substantially eliminating problems associated with a lattice-mismatched substrate is to grow on lattice-matched native growth substrates. For example, for GaN-based devices this means using native GaN substrates. Since the cost of such substrates is much higher than other alternatives it has not been widely adopted as a commercially viable solution.

In light of the above, it is clear that there is a need in the industry for epilayer technologies that provide epilayers for active devices, such as GaN-based LED and HEMTs, that use inexpensive substrates while avoiding the problems associated a lattice-mismatched substrate.

It is an aim of embodiments of the present invention to address the aforementioned problem.

### SUMMARY OF THE INVENTION

As described in the background section, native semiconductor growth wafers generally comprise a native growth substrate, an active semiconductor layer structure, and one or more strain-matching layers disposed between the native growth substrate and the active semiconductor layer structure. The strain-matching layers are exceedingly thin (e.g. of the order of one micrometer in thickness or of nanometer scale), and thus would not be expected to significantly impact the thermal performance, reliability, and lifetime of semiconductor devices fabricated on such a native semiconductor growth wafer. Additionally, the strain-matching layers are usually spaced apart from semiconductor devices fabricated on the active semiconductor layer structure by a significant distance due to the presence of a semiconductor buffer layer. As such, it would be expected that the presence of very thin strain-matching layers disposed a significant distance from the semiconductor device structures would not significantly impact device performance.

The present inventors have surprisingly found that the presence of strain-matching layers within semiconductor device structures has a large detrimental effect on the reliability and lifetime of the semiconductor device structures, even when the strain-matching layers are exceedingly thin and even when the strain-matching layers are spaced apart from active regions of device structures by a thick buffer layer. This is particularly the case for high frequency and/or high power devices and/or devices which operate at high temperature.

While not being bound by theory, it is believed that the large detrimental impact of strain-matching layers on the reliability and lifetime of semiconductor device structures may be due to two effects:
(1) While the strain-matching layers may be very thin and spaced apart from active device structures, the layers are highly dislocated. During operation of a semiconductor device, particular one operating at high power and/or high frequency, the device becomes very hot. Dislocations and/or other defects within the strain-matching layers then propagate upwards into the active semiconductor layer structure in use and detrimentally effect performance, eventually leading to premature failure of the device.
(2) Thermal stress during device operation may result in defects within the strain matching layers becoming charged, thus creating electric fields which detrimentally effect performance, eventually leading to premature failure of the device.

That is, thermal stress during device operation, particularly in high power and/or high frequency devices, results in dislocations propagating out of the highly dislocated strain-matching layers and/or new defect generation, both of which have a detrimental effect on device performance via threading dislocations reaching into the active semiconductor layer structure and/or electrical fields created by defects disturbing charge transport in the active semiconductor layer structure. During the long-term operation of these devices at high temperatures, these effects become significant and cause device failure.

For devices such as AlGaN/GaN high-electron mobility transistors which are grown on lattice-mismatched native substrates, it is not possible to eliminate the aforementioned problem since the strain-matching layers are an integral part of the epilayer/substrate structure.

Furthermore, while it is also known in the art that in certain applications it is beneficial to transfer the active semiconductor layers from the native growth substrate to another substrate, usually one which has better heat spreading capabilities, this transfer process has always resulted in the native strain-matching layers also being transferred. This was not previously considered to be problematic as it was assumed that the very thin strain-matching layers would not significantly impact device performance as previously indicated. Furthermore, to remove the strain-matching layers requires a carefully controlled removal process given that the stain matching layers are very thin and necessarily of a very similar crystal structure to the active semiconductor layers to achieve their strain matching functionality. As such, unless there is a significant advantage to removing these strain-matching layers when transferring the active semiconductor layer structure to a heat spreading substrate, there would be no motivation to do so given the additional time and expense that the removal process would entail.

The present inventors have been utilizing a process to transfer active semiconductor layer structures from their native growth substrates to other working substrates to achieving better thermal heat spreading for high power and/or high frequency device applications. It was expected that better heat spreading capability would lead to a significant increase in the reliability and lifetime of such devices. However, when the performance of devices fabricated using such a transfer process was tested it was found that the performance of the devices in terms of device reliability and lifetime did not increase to the expected levels.

The inventors have traced the problem to the presence of the native strain-matching layers. Even with improved heat spreading, it has been found that thermal stresses during operation cause defects within the native strain-matching layers to have a significant impact on the reliability and lifetime of the devices. After modifying the transfer process to including a step of carefully removing the strain-matching layers, for example using a well-controlled etching process, it has been found that the reliability and lifetime of the devices improved dramatically. This is considered by the inventors to be a profound result.

In addition to the above, for certain applications it has also been found to be advantageous to remove a portion of the active semiconductor layer structure in addition to removing the native strain-matching layers. It is considered that dislocations originating during growth of the active semiconductor layer structure on the native growth substrate can propagate through the strain matching layers into a portion of the active semiconductor layer structure above the strain matching layers. In this case, it is advantageous to remove this dislocated portion of the active semiconductor layer structure for the same reasons as given above for removal of the strain matching layers, e.g. a portion of a buffer layer, such as a GaN buffer, disposed over the strain matching layers may also be removed.

In light of the above, the present specification describes methods for manufacturing semiconductor wafer structures which exhibit improved lifetime and reliability. The methods comprise transferring an active semiconductor layer structure from a native non-lattice-matched semiconductor growth substrate to a working substrate, wherein strain-matching layers, and optionally a portion of the active semiconductor layer structure, are removed. In certain embodiments, the process of attaching the active semiconductor layer structure to the working substrate includes annealing at an elevated temperature for a specified time.

According to one aspect of the present invention there is provided a method of manufacturing a working semiconductor wafer structure for semiconductor device fabrication thereon, according to claim 1.

According to certain embodiments, one or more of the single crystal strain-matching layers may be removed before, during, or after transferring at least a portion of the active semiconductor layer structure to the working substrate. The one or more single crystal strain-matching layers which are removed will general be highly dislocated and may have a concentration of dislocation defects of at least 1 x 10⁶ defects/cm², 1 x 10⁷ defects/cm², 1 x 10⁸ defects/cm², 1 x 10⁹ defects/cm², or 1 x 10¹⁰ defects/cm². Furthermore, the one or more single crystal strain-matching layers which are removed may have a thickness of at least 1nm 10 nm, 50 nm, 100 nm, 200 nm, 500 nm, or 1 micrometer and/or a thickness of no more than 10 micrometers, 5 micrometers, 2 micrometers or 1 micrometer. The thickness of the strain-matching layer structure will depend on the particular combinations of materials which are used and the relative lattice mismatch between an underlying substrate and an overlying active semiconductor layer structure.

One further advantage of the present invention is that as strain-matching layers are removed, the requirement to keep these layers as thin as possible in the original native growth wafer is negated. As such, thicker strain matching layer structures can be provided in the native growth wafer if desirable, and then these thick strain-matching layers can be removed when the active semiconductor layer structures is transferred to the working substrate.

According to certain embodiments the method further comprises removing a portion of the active semiconductor layer structure proximate to the strain-matching layer of the native semiconductor growth wafer after removing the strain-matching layer structure, whereby the working semiconductor wafer structure only comprises a portion of the active semiconductor layer structure which was distal to the native growth substrate in the native semiconductor growth wafer.

The methods as described herein can be used to fabricate working semiconductor wafer structures which do not comprise highly dislocated strain-matching layers which are present in the native semiconductor growth wafer. As such, according to another aspect of the present invention there is provided a working semiconductor wafer structure comprising:
a working substrate; and
an active semiconductor layer structure bonded to the working substrate, and
wherein the working semiconductor wafer structure does not include a single crystal strain-matching layer structure disposed between the working substrate and the active semiconductor layer structure which has a thickness of at least 1 micrometer, 500 nm, 200 nm, 100 nm, 50 nm, 10 nm, or 1 nm and/or a concentration of dislocation defects of at least 1 x 10¹⁰ defects/cm², 1 x 10⁹ defects/cm², 1 x 10⁸ defects/cm², 1 x 10⁷ defects/cm², or 1 x 10⁶ defects/cm².

While the aforementioned definition envisages the removal of at least the most highly dislocated and/or thick strain-matching layers, preferably all the strain matching layers are removed such that the working semiconductor wafer structure does not include any single crystal strain-matching layers disposed between the working substrate and the active semiconductor layer structure.

The methods as described herein can also be used to fabricate working semiconductor wafer structures which have a low concentration of dislocation defects in the active semiconductor layer structure. For example, the active semiconductor layer structure may comprise a concentration of dislocation defects in a layer distal to the working substrate and/or in a layer proximal to the working substrate which is less than 1 x 10⁸ defects/cm², 5 x 10⁷ defects/cm², 1 x 10⁷ defects/cm², 5 x 10⁶ defects/cm², or less than 1 x 10⁶ defects/cm².

The working semiconductor wafer structure may further comprise a functional layer disposed between the active semiconductor layer structure and the working substrate. In this case, if the functional layer is a single crystal layer, it can be distinguished over the single crystal strain matching layers of the native growth wafer in that it will not be so highly dislocated. For example, the functional layer may have a concentration of dislocation defects which is less than 1x10⁸ defects/cm², less than 5 x 10⁷ defects/cm², less than 1 x 10⁷ defects/cm², less than 5 x 10⁶ defects/cm², or less than 1 x 10⁶ defects/cm². That said, for many applications the functional layer will have an amorphous or polycrystalline structure and thus will be distinct from the single crystal strain matching layers of the native growth wafer.

### BRIEF DESCRIPTION OF THE DRAWINGS

To further clarify the above, and understand the advantages and features of the present invention, a more particular description of the invention will be rendered by reference to specific embodiments thereof which are illustrated in the appended drawings. These drawings depict only typical embodiments of the invention and are therefore not to be considered limiting of its scope.
- Figure 1:: A high-electron mobility structure (PRIOR ART).
- Figure 2:: An exemplary high-electron mobility transistor with highlighted structural features relevant for reliability.
- Figure 3:: Illustration of method A: (A) Starting and ending wafer structures; and (B) flowchart.
- Figure 4:: Illustration of method B: (A) Starting and ending wafer structures; and (B) flowchart.
- Figure 5:: Illustration of method C: (A) Starting and ending wafer structures; and (B) flowchart.
- Figure 6:: Schematic of circuit used in lifetime testing of AlGaN/GaN on diamond.
- Figure 7:: Lifetime test data: (A) GaN/Si sample; and (B) GaN/Diamond sample.
- Figure 8:: Epilayer structure of (A) GaN-on-Diamond; and (B) GaN/silicon transistors tested.
- Figure 9(A):: GaN/Silicon devices drain current (IDSS) during first 5,000 hours of life-test at 215°C.
- Figure 9(B):: GaN-on-diamond devices IDSS during first 5,000 hours of life-test at 215°C.
- Figure 10(A):: GaN/Silicon devices IDSS at 290°C.
- Figure 10(B):: GaN-on-diamond devices IDSS at 290°C.
- Figure 11(A):: GaN/Silicon devices IDSS at 350°C.
- Figure 11(B):: GaN-on-diamond devices IDSS at 350°C.
- Figure 12:: Gate-leakage current measured on 6 GaN-on-Si devices biased with a Source-Drain voltage of 24V. Channel temperature is maintained at 290°C.
- Figure 13:: Gate-leakage current measured on 6 GaN-on-Diamond devices biased with a Source-Drain voltage of 24V. Channel temperature is maintained at 290°C.
- Figure 14:: Gate-leakage current measured on 6 GaN-on-Si devices biased with a Source-Drain voltage of 24V. Channel temperature is maintained at 350°C.
- Figure 15:: Gate-leakage current measured on 6 GaN-on-Diamond devices biased with a Source-Drain voltage of 24V. Channel temperature is maintained at 350°C.

### DETAILED DESCRIPTION OF THE INVENTION

As described in the summary of invention section, this specification discloses methods for achieving improved reliability of semiconductor devices by transferring the active device epilayers from a native growth substrate onto a new substrate, wherein in this process at least a portion, and optionally all, of the nucleation/transition/strain-matching layers disposed between the original growth substrate and the active device epilayers are removed. In some cases the process of attaching the epilayers to the new substrate is performed at an elevated temperature for a prescribed period of time.

The methodology as described herein may be applied to a range of native semiconductor growth wafers. For example, the native semiconductor growth substrate may be formed of a material selected from a group consisting of: silicon; silicon carbide; silicon nitride; aluminum nitride; and sapphire. The methodology as described herein is particularly useful when the native semiconductor growth substrate has a first crystal structure and the active semiconductor layer structure has a second crystal structure different from said first crystal structure.

For certain applications the steps of transferring the active semiconductor layer structure and removing the one or more strain-matching layers will comprise:
attaching the working substrate to the active semiconductor layer structure of the native semiconductor growth wafer;
removing the native growth substrate; and
removing one or more of the single crystal strain-matching layers to form a working surface of the active semiconductor layer structure in the working semiconductor wafer structure.

The working substrate may be attached to the active semiconductor layer structure of the native semiconductor growth wafer via a functional layer disposed between the working substrate and the active semiconductor layer structure.

In the aforementioned case, the active semiconductor layer structure will be flipped such that it has a growth direction which points towards the working substrate. In some applications it is desirable to retain the orientation of the active semiconductor layer structure. In these cases the steps of transferring the active semiconductor layer structure and removing the one or more strain-matching layers may comprise:
attaching a transfer substrate to the active semiconductor layer structure of the native semiconductor growth wafer;
removing the native growth substrate;
removing one or more of the single crystal strain-matching layers;
attaching the working substrate to the active semiconductor layer structure; and
removing the transfer substrate to form a working surface of the active semiconductor layer structure in the working semiconductor wafer structure.

The transfer substrate may be attached to the active semiconductor layer structure of the native semiconductor growth wafer via a protective layer, which may be an amorphous or polycrystalline material, disposed between the transfer substrate and the active semiconductor layer structure. In this case, after removing the transfer substrate the protective layer is also removed to reveal the working surface of the active semiconductor layer structure in the working semiconductor wafer structure. Furthermore, the working substrate may be attached to the active semiconductor layer structure via a functional layer disposed between the working substrate and the active semiconductor layer structure.

Using this methodology the orientation of the active semiconductor layer structure is retained with the active semiconductor layer structure having a growth direction which points away from the working substrate.

Advantageously, an anneal is applied during attachment of the working substrate to the active semiconductor layer structure, said anneal being at a temperature of at least 500°C, 550°C, 600°C, 650°C, or 700°C for a time of at least 75 hours, 100 hours, 150 hours, 200 hours, or 240 hours.

After applying the aforementioned methodology, at least one electronic or optoelectronic device can be fabricated on the active semiconductor layer structure in the working semiconductor wafer structure.

The details of the device-life improvement reasoning and methodology will be illustrated on the epilayer structure of an exemplary AlGaN/GaN high-electron mobility transistor shown in Figure 2.

GaN and related materials are presently grown on lattice-mismatched substrates and, as discussed in the background section, require one or more intermediate nucleation/transition/strain-matching layers to alter the lattice constant (or crystal structure) of the native growth substrate to the desired lattice constant (or crystal structure) of the active semiconductor layer(s). The purpose of the underlying nucleation/transition/strain-matching layers is to absorb strain and in some cases terminate dislocations created by the change in lattice constant between the growth substrate and overlying semiconductor layer(s) grown thereover.

Furthermore, by growing a sufficiently thick semiconductor buffer layer over the nucleation/transition/strain-matching layers (e.g. a GaN buffer layer), further active semiconductor layer(s) grown on the buffer layer are distanced from the nucleation/ transition/strain-matching layers and the defect density is reduced to a level that allows the growth of high quality active layer(s) on top of the buffer layer.

Nucleation layers are sandwiched between a single-crystal substrate and single-crystal epilayers which make the active layer(s) of the device. For GaN-based devices, nucleation layers are, for example, anything that appears between the single-crystal substrate and the GaN buffer. If there is no GaN buffer then, any indispensable part of the electronic device grown on that growth substrate.

These features are illustrated with the epilayer structure shown in Figure 2. An exemplary high-electron mobility field-effect transistor comprises a native substrate 201 on top of which are deposited the nucleation/transition/strain-matching layers 202, a GaN buffer 203, which is topped with an AlGaN barrier is 206. The epitaxial growth starts with first forming the nucleation layers 102 to adopt the lattice constant to GaN (or a related alloy), followed by growing a sufficient thickness of the GaN buffer 103 before the AlGaN barrier is grown. The dislocation density and the thermal resistance of the buffer layer reduces with its thickness and hence a new thickness, indicated with 217, may be more suited for desired device properties. The layers that perform the active function of the electronic/optoelectronic device (top of the buffer layer and the AlGaN barrier, for example) together with the buffer layer 203 are referred to as the active layered structure layer, or just active layer for short, and are denoted by label 207 in Figure 2.

As has already been described in connection with Figure 1, the region of the GaN buffer 203 closest to the AlGaN barrier 206 may also include an under-channel barrier (not shown) or other specific features that improve the performance of such field-effect transistors as is known in the art.

Once the epitaxial growth is complete, the wafer is processed using standard semiconductor techniques to define electronic devices, in this case, a field-effect transistor by depositing metals to form ohmic contacts for the source 210 and the drain 213 terminals and Schottky contact to form the gate 211 terminal. The chip backside is denoted with 216. The active layers may comprise multiple layers of AlGaN or InGaN semiconductor alloys or GaN, AlN, InN or any other related material to realize the desired electrical performance of the electronic or optoelectronic device.

Removing the nucleation layers 202 and thinning down the buffer layer 203 improves the reliability in at least of the following ways:
(1) Removing the dislocated crystal below the active layer eliminates a source of strain in the device. It also prevents of dislocations or defects propagating upwards into the active layer in use.
(2) Thermal stress during device operation may create defects that become charged and new electric fields disturb device performance. By eliminating the nucleation layers, and optionally a portion of the adjacent buffer layer, and replacing them with materials that are electrically and mechanically stable, this prevents any new electrical disturbances to the device in use.

The objective is to improve the reliability of semiconductor devices. This specification discloses a number of methods A to C as set out below for manufacture of wafers and devices and discloses a number of preferred wafer and hence device structures that include epilayer structures and device configurations that result in the above-mentioned improvements. Any one of presented methods and embodiments may be used by themselves and in combination with other disclosed embodiments to achieve an improvement in performance. Described examples relate to methods for manufacturing GaN-on-substrate engineered wafers that enable electronic and/or optoelectronic devices with improved reliability. The block diagrams of the method embodiments and the vertical cross-sectional epilayers/substrates schematics of the engineered wafers structures are illustrative and are not meant to be limiting. The overall process in making engineered wafers comprises of a large number of intermediate steps which are generally known to a person skilled in the art.

Method A discloses on a high level, the method for improving the reliability of electronic devices originally manufactured on lattice mismatched substrates. Method B discloses an alternative to method A in which the active layers in the final product are flipped upside down relative to the as-grown orientation. Method B is illustrated on creating engineered wafers for manufacturing light-emitting diodes. Method C is a refinement to method A applied to light-emitting diodes and field-effect transistors in which the as-grown active layer orientation is preserved in the final product.

Terminology used in all methods is discussed next. The word "native substrate" means a substrate or a wafer that has single-crystal structure as it is produced by any one of the known methods for manufacturing wafers (or substrates) for the semiconductor industry, including epitaxial growth. A native substrate may be a single-atom or two-atom (binary alloy) crystal. In some situations the crystal may be a ternary alloy. A single-crystal wafer is characterized by a lattice structure and associated lattice parameters. As discussed previously, lattice structures of common native substrates used for growth of GaN are either cubic or hexagonal. A hexagonal lattice has two lattice constants: a basal lattice constant commonly denoted with *a*; and a lattice constant perpendicular to the (0001) plane of the hexagonal lattice commonly denoted with c. Hexagonal gallium nitride is typically grown on the (0001) surface of hexagonal substrates such as sapphire or 4H and 6H polymorphs of silicon carbide. The lattice mismatch relevant for this growth is between the basal lattice constants of GaN and the substrate (e.g. SiC or sapphire). When GaN is grown on cubic lattices (silicon or diamond) the cubic crystal may be cut along the (111) plane and in this case the basal lattice constant of GaN is attempting to match the lattice structure and lattice constant along a plane perpendicular to the growth direction. The substrate may also be cut at an angle which changes the crystal structure and the lattice constants exposed on the plane perpendicular to the growth direction. For each growth combination, one can determine the relevant lattice constants and the lattice mismatch in a straightforward fashion by knowing the lattice structure and lattice constants of the two materials being joined. One also has to take into account that the crystal forms at the growth temperature (>1000°C for GaN) and that the lattice mismatch at operating temperature will be different. Computing these lattice mismatches for different materials and techniques for growing GaN on a variety substrates is generally known in the art. Finally, basal lattice constant means the lattice constant or constants in the plane perpendicular to the growth direction, namely, lattice parameters relevant for crystal growth, whether the crystal lattice is hexagonal or cubic, or cut at an off-angle.

As previously described, lattice mismatch is quantified as the basal lattice constant *a*_{GaN} of the epilayer (GaN) relative to the lattice constant of the substrate *a*ₛᵤₜ: (*a*_{GaN} - *a*_{sub})/*a*_{sub} and expressed in percentage, where *a*_{GaN} and *a*_{sub} are basal lattice constants and subscript "sub" refers to the lattice constant of the substrate or the layer on top of which GaN is grown. The maximum thickness of an epilayer that can be grown free of dislocations on a lattice-mismatched substrate is referred to as critical thickness. Critical thickness will primarily depend on the lattice mismatch. For lattice mismatch 1%, critical thickness for most materials is significantly smaller than the required active layer thickness.

Growth direction is a direction in which the crystal grows during epitaxial growth. Examples of epitaxial growth techniques used from growing GaN are metal-organic vapor phase epitaxy (MOCVD) and molecular beam epitaxy (MBE). The growth direction (also growth direction vector) is perpendicular to the surface of the wafer on top of which the epitaxial layers are grown (also perpendicular to the surface of the epitaxial layers for planar growth) and it points in the direction of crystal growth, i.e., away from the substrate (or base) on top of which the crystal is being grown. For a native growth substrate as defined above, the growth direction is perpendicular to the surface of the substrate and it points from the substrate toward the epitaxial layers (active layers). For the purposes of this application, growth direction is an attribute of an epitaxial layer (not the epitaxial layer on a substrate). It characterizes the crystal growth order in which the layer was created. Knowledge of this property is particularly important in hexagonal crystals.

### Method A

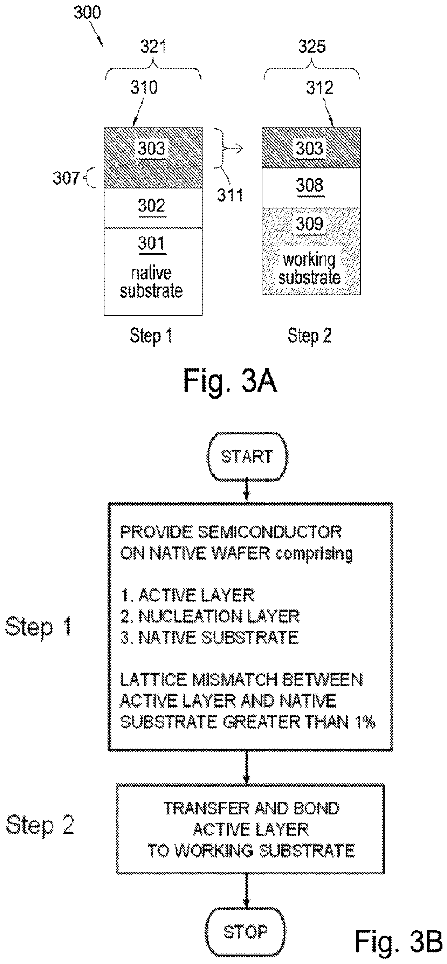

Method A is explained with reference to Figure 3 where vertical cross-sectional schematics of the engineered wafer structures 300 (Figure 3A) and the associated method flow chart (Figure 3B) are shown.

In Step 1, a semiconductor-on-substrate 321 is provided. The structure 321 is also referred to as the native wafer 321 and it comprises a single-crystal native substrate 301, nucleation layers 302 disposed on top of the native substrate 301, and an active layered structure layer 303 disposed on top of the nucleation layers 302. The revealed surface of the active layered structure layer 303 is referred to as the epilayer surface 310. The native substrate 301 has a basal lattice constant that is different from that of the active layered structure layer 303 by more than 1% (e.g. as measured at room temperature, 25°C). In such a situation, the dislocations originating during the growth on a lattice mismatched substrate, terminate within the nucleation layer 302 and in some cases propagate to a portion of the layer above the nucleation layer 302; into a part of the active layered structure layer 303 bounded by the dashed line 307. In accordance with embodiments of the present invention this dislocated region of crystal material is to be removed such that defects cannot subsequently propagate upwards into the active region of the device and/or become charge causing electric fields disturbing device performance. In addition, apart from removal of dislocation defects, removal of a portion of the buffer layer below line 307 can also have the advantage of reducing the thickness of active layer 303 which can improve device operation for certain applications.

In the structure illustrated in Figure 3, the horizontal line 307 is located within the GaN buffer layer although it may alternatively be located at the bottom of the GaN buffer layer, i.e., at the heterojunction between the GaN buffer layer (which is a part of the active layer 303) and the nucleation layer 302. The epilayer/substrate structure of this native wafer 321 exemplifies the typical structure of AlGaN/GaN high-electron mobility transistors or light-emitting diodes grown on silicon, silicon carbide, or sapphire substrate. In these devices, the part of the active layered structure layer below the line 307 is in the GaN buffer. The structure also exemplifies any other device in which the lattice constant of the substrate is different from that of the active layered structure.

In Step 2, a portion 305 of the active layered structure layer 303 above the region 307 is transferred to a new substrate referred to as the working substrate 309 as is indicated with the bracket and arrow 311. The method for attaching the portion 305 of the active layer 303 to the working substrate 309 is facilitated with a functional layer 308 sandwiched between the working substrate 309 and the portion 305 of the active layer 303. The attachment is accomplished by either wafer bonding or by growing the working substrate 309 on top of the layer 308 by chemical-vapor deposition or other techniques for amorphous or crystalline growth known in the art. The material choices for the working substrate 309 are silicon, silicon carbide, aluminum nitride, synthetic diamond, boron nitride, silicon nitride to name some preferred examples in single or multicomponents forms. The revealed surface of the portion 305 is referred to as the working surface 312 and it may coincide with the original epilayer surface 310. The functional layer may be a multilayered structure layer including metals, amorphous, or polycrystalline materials. The process of transferring the portion 305 to a working substrate 309 may also flip the epilayers so that the working surface 312 is not the same crystal surface as the epilayer surface 310. The completed engineered wafer 325 is now ready for electronic or optoelectronic device processing using methods known in the art.

The method for manufacturing engineered wafers in accordance with method A comprises:
providing a native wafer 321 comprising a single-crystal native substrate 301 having a first lattice constant *x*₁, an active layered structure layer 303 having a second lattice constant *x*₂ different from said first lattice constant by at least 1%, said active layered structure layer 303 having a working surface 310, and a nucleation layer 302 sandwiched between said native substrate 301 and said active layered structure layer 303, and distal from said working surface 310; and
forming a working wafer 325 by transferring at least a portion 305 of said active layered structure layer 303 to a working substrate 309, wherein the working wafer 325 does not include the nucleation layer 302 of the native wafer 321.

In the illustrated embodiment, the working or engineered wafer 325 comprises a functional layer 308 sandwiched between the portion 305 of the active layered structure layer and the working substrate 309.

The portion 305 of the active layered structure layer 303 may comprise at least one layer made out of gallium nitride. The functional layer 308 may be amorphous or polycrystalline structure. In certain applications, the functional layer 308 may be made of at least one metal layer. In certain applications, the functional layer 308 may be selected from a group consisting of silicon nitride, aluminum nitride, and silicon carbide.

The native substrate 301 may be made out of a material selected from a group consisting of silicon, silicon carbide, aluminum nitride, and sapphire. In certain applications, the working substrate 309 may be made out of a material selected from a group consisting of silicon carbide, aluminum nitride, sapphire, and silicon. In certain applications, the working substrate 309 may be made out of amorphous or crystalline material. In yet further applications, the native substrate 301 has a first crystal structure and the active layered structure layer 303 has a second crystal structure different from the first crystal structure.

### Method B

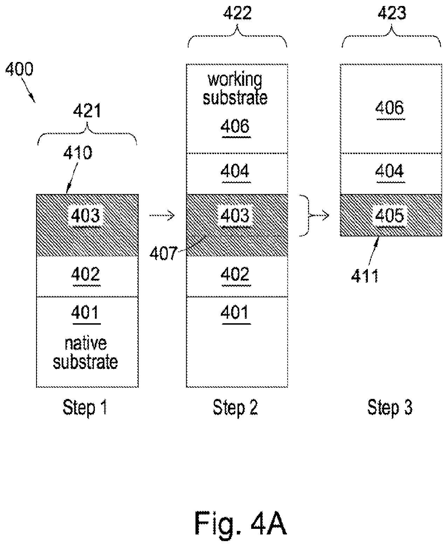

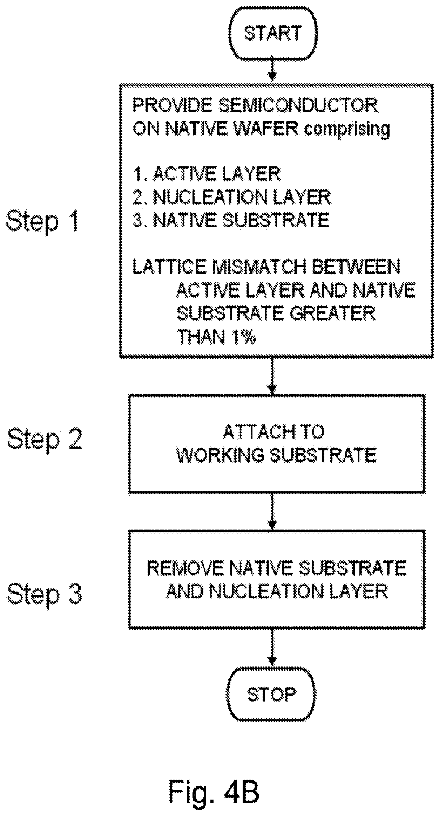

Method B further refines the concepts disclosed in method A and applies them to the manufacturing of electronic or optoelectronic devices in which the epilayers (active layers on the native substrate) are designed so that the growth direction of the active layer on the completed engineered wafer points towards the working substrate. Examples are non-polar, semi-polar, and polar GaN-based transistors or light-emitting devices. Method B is explained with the help Figure 4 where vertical cross-sectional schematics of the engineered wafer structures 400 (Figure 4A) and the associated method step block diagram (Figure 4B) are shown.

In Step 1, a semiconductor-on-substrate wafer 421 is provided. The structure 421 is also referred to as the native wafer 421 and it comprises a single-crystal native substrate 401, nucleation layers 402 disposed on top of the native substrate 401, and an active layered structure layer 403 disposed on top of the nucleation layers 402. Native substrate means a single-crystal wafer characterized with at least the basal lattice constant and crystal structure. The revealed surface of the active layered structure layer 403 is referred to as the epilayer surface 410. The active layered structure layer 403 has a growth direction pointing away from the native substrate 401 and towards the epilayer surface 410. The native substrate 401 has a lattice constant that is different from that of the active layered structure layer 403 by at least 1%. In such a situation, the dislocations originating during the growth on substrate 401 terminate within the nucleation layer 402 and in some cases propagate to a portion of the layer above the nucleation layer 402 into a part of the active layered structure layer 403 bounded by the dashed line 407. Alternatively or additionally, the required thickness of active layer 403 for optimal device operation may be thinner than that of the native wafer 421, indicated by the horizontal line 407.

The horizontal line 407 is located within the GaN buffer layer or at the bottom of the GaN buffer layer, i.e., at the heterojunction between the GaN buffer layer (which is a part of the active layer 403) and the nucleation layer 402. The epilayer/substrate structure of this native wafer 421 exemplifies the structure of a non-polar or semi-polar AlGaN/GaN high-electron mobility transistor or light-emitting device grown on silicon, silicon carbide, or a sapphire substrate. In these devices, the part of the active layered structure layer below the line 407 is in the GaN buffer. The structure also exemplifies any other device in which the lattice constant of the substrate is different from that of the active layered structure.

In Step 2, the active layered structure layer 403 is attached to a working substrate 406 using a functional layer 404 disposed between the active layer 403 and the working substrate 406. The functional layer 404 may be a multilayered structure layer including metals, amorphous, or polycrystalline materials. In a top emitting light-emitting diode, the bonding layer 404 serves also as a mirror for light emittion by the active layered structure layer 403, and will comprise at least one metal layer. In a AlGaN/GaN HEMT, the functional layer 404 may be an amorphous or polycrystalline dielectric. The composite wafer structure is referred to as structure 422.

In Step 3, the native substrate 401, the nucleation layer 402, and optionally a fraction of the active layered structure layer 403 up to the line 407 are removed using, for example, a combination of chemical and dry etching. The remaining portion 405 of the active layer 403 becomes a part of the completed structure 423. The structure 423 has a working surface 411 revealed and is ready for fabricating optoelectronic or electronic devices on its surface 411 using methods known in the art of manufacturing semiconductor devices.

The method for manufacturing high-reliability electronic devices in accordance with method B comprises:
providing an epilayer wafer 421 comprising a single-crystal native substrate 401 having a first lattice constant *x*₁, an active layered structure layer 403 having a second lattice constant *x*₂, different from said first lattice constant by at least 1%, said active layer having a top surface 410, and a nucleation layer 402 sandwiched between said native substrate 401 and said active layered structure layer 403;
bonding a working substrate 406 to said active layered structure layer 403, for example using a functional layer 404 between said working substrate 406 and said active layered structure layer 403;
removing said native substrate 401; and
removing said nucleation layer 402 to reveal a working surface 411 of the active layered structure layer.

According to certain embodiments, removal of the nucleation layer 402 may be followed by removal of at least a portion of the active layered structure layer 403.

After the aforementioned method steps, at least one electronic or optoelectronic device can be fabricated on the working surface 411.The active layered structure layer 405 may comprise at least one layer made out of gallium nitride. The native substrate 401 may be made out of a material selected from a group consisting of silicon, silicon nitride, aluminum nitride, and sapphire. The working substrate 406 may be made out of a material selected from a group consisting of deposited diamond, silicon carbide, aluminum nitride, sapphire, and silicon to name some preferred examples. The working substrate 406 may be made out of amorphous or crystalline material. The functional layer 404 may be made out of at least one metal layer. Alternatively, the functional layer 404 may be made out of an amorphous or polycrystalline material.

Using the aforementioned methodology, the growth direction of the active layered structure layer 403 points towards the working substrate 406.

### Method C

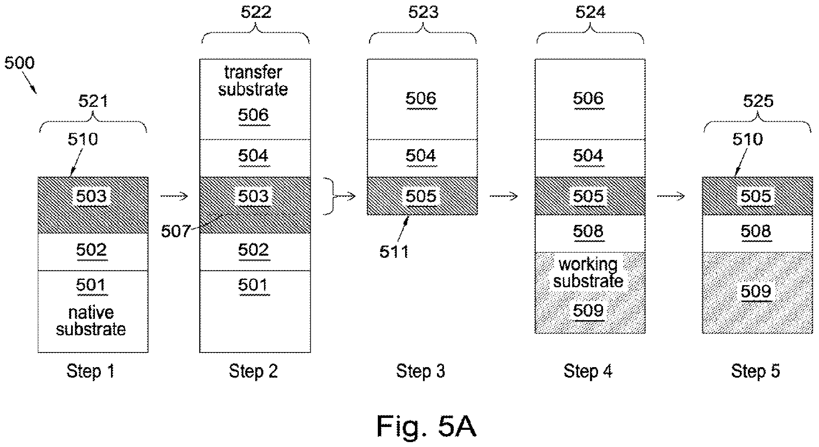

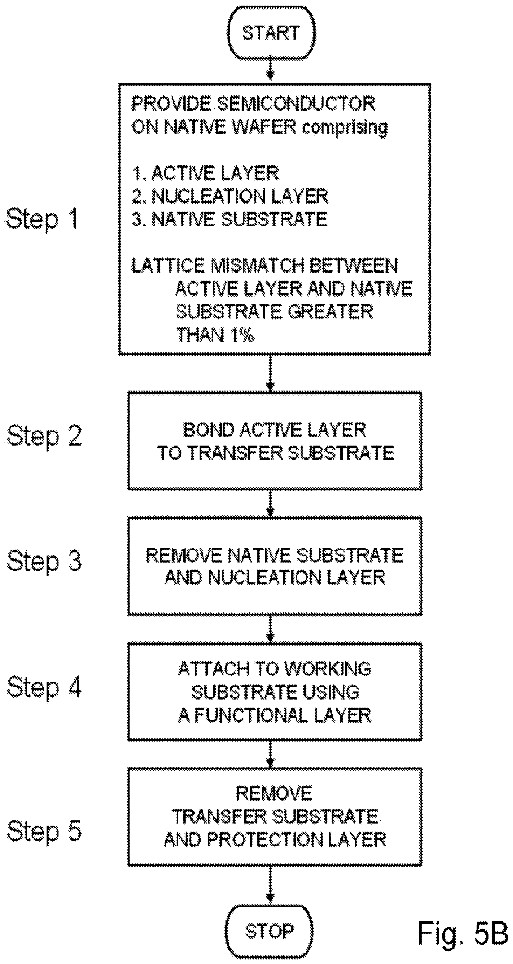

Method C further refines the concepts disclosed in method A and applies them to the manufacturing of improved-reliability electronic devices in which the crystal growth orientation has to be preserved, such as in high-electron mobility transistors. Devices other than high-electron mobility transistors may be manufactured using the same method or an equivalent variation of method C. Method C is explained with reference to Figure 5 where vertical cross-sectional schematics of the engineered wafer structures 500 (Figure 5A) and the associated method step block diagram (Figure 5B) are shown.

In Step 1, a semiconductor-on-substrate wafer 521 is provided. The structure 521 is also referred to as the native wafer 521 and it comprises a single-crystal native substrate 501, nucleation layers 502 disposed on top of the native substrate 501, and an active layered structure layer 503 disposed on top of the nucleation layers 502. The revealed surface of the active layered structure layer 503 is referred to as the working surface 510. The native substrate 501 has a lattice constant that is different from that of the active layered structure layer 503. The (basal) lattice constant in the growth plane of the active layer 503 is different from the lattice constant in growth plane of the substrate (501) by more than 1%. In such a situation, the dislocations originating during the growth on a lattice mismatched substrate, terminate within the nucleation layer 502 and in some cases propagate to a portion of the layer above the nucleation layer 502 into a part of the active layered structure layer 503 bounded by the dashed line 507. Alternatively or additionally, the required thickness of active layer 503 for optimal device operation may be thinner as indicated by the horizontal line 507.

The horizontal line 507 is located within the GaN buffer layer or at the bottom of the GaN buffer layer, i.e., at the heterojunction between the GaN buffer layer (which is a part of the active layer 503) and the nucleation layer 502. The epilayer/substrate structure of this native wafer 521 exemplifies the structure of a polar AlGaN/GaN high-electron mobility transistor grown on silicon, silicon carbide, or sapphire substrate. In these devices, the part of the active layered structure layer 503 below the line 507 is in the GaN buffer. The structure also exemplifies any other device in which the lattice constant of the substrate is different from that of the active layered structure.

In Step 2, the active layered structure layer 503 is attached to a transfer substrate 506 using a protection layer 504. The protection layer may be made of robust dielectric such as silicon nitride, silicon oxide, or polysilicon that will not react with the working surface 510 during further processing. The protection layer 504 may comprise a multiplicity of layers to promote protection and adhesion. The composite wafer structure is referred to as structure 522.

In Step 3, the native substrate 501, the nucleation layer 502, and optionally a fraction of the active layered structure layer 503 up to the line 507, are removed using, for example, a combination of chemical and dry etching. The remaining portion of the active layered structure layer 503 is referred to as portion 505. The revealed surface 511 may be within the GaN buffer of the active layer 503 or at the bottom of the GaN buffer of active layer 503. The thickness of portion 505 of the active layer 503 may be smaller or equal to the thickness of active layer 503. The remaining structure is referred to as composite structure 523.

In Step 4, the composite structure 523 is attached to a working substrate 509 by means of a functional layer 508 sandwiched between the working substrate 509 and the portion 505 of the active layered structure layer 503. The functional layer 508 may be a multilayered structure layer including metals, amorphous, or polycrystalline materials. In one embodiment, the step of attaching is performed under an elevated temperature anneal executed at a temperature of at least 700°C and for a time longer than 75 hours. In yet another embodiment, the anneal time is up to or longer than 240 hours. The epilayer/substrate stack-up at the end of step 4 is referred to as composite substrate 524.

In Step 5, the transfer substrate 506 and the protection layer 504 are removed by, for example, wet or dry etching and a working surface 510 of the active layered structure layer is revealed again. The engineered wafer 725 is now ready for device fabrication. Optoelectronic or electronic devices may now be fabricated on the surface 510.

The method for manufacturing high-reliability electronic device wafers in accordance with method C comprises:
providing a native wafer 521 comprising a single-crystal native substrate 501 having a first lattice constant *x*₁, an active layered structure layer 503 having a second lattice constant *x*₂, different from said first lattice constant *x*₁ by at least 1%, said active layered structure layer 503 having a working surface 510, and a nucleation layer 502 sandwiched between said native substrate 501 and said active layered structure layer 503;
depositing a protection layered structure layer 504 on said working surface 510;
attaching a transfer substrate 506 to the protection layered structure layer 504;
removing said native substrate 501;
removing said nucleation layer 502 and optionally a fraction of said active layered structure layer 503, revealing a bottom surface 511 of at least a portion 505 of said active layered structure layer 503;
depositing a functional layer 508 on said bottom surface 511;
attaching a working substrate 509 to said functional layer 508, optionally using a high temperature anneal;
removing said transfer substrate 506; and
removing said protection layered structure layer 504 to reveal said working surface 510.

Where a high temperature anneal is used to attach the working substrate 509 to the functional layer 508, the anneal may be at an anneal temperature of at least 700°C and an anneal time of at least 75 hours. Accordingly to certain embodiments, the anneal time may be at least 240 hours.

After performing the aforementioned method steps, at least one electronic device can be fabricated on said working surface 510.

As with the previously described methods, at least one portion 505 of the active layered structure layer 503 may comprise at least one layer made out of gallium nitride.

Alternatively, or additionally, at least one portion 505 of the active layered structure layer 503 may comprise at least one layer made out of indium gallium nitride.

The native substrate 501 may be made out of a material selected from a group consisting of silicon, silicon nitride, silicon carbide, aluminum nitride, and sapphire. Furthermore, the working substrate 509 may be made out of a material selected from a group consisting of chemical-vapor deposited diamond, silicon carbide, aluminum nitride, sapphire, silicon, silicon nitride to name some preferred examples. The working substrate 509 may be made out of amorphous or crystalline material. The functional layer 508 may be made out of at least one metal layer. Alternatively, the functional layer 508 may be made out of amorphous or polycrystalline materials. The protection layered structure layer 504 may also be made out of at least one amorphous or polycrystalline material.

Using the aforementioned methodology, the active layered structure layer 503 has a growth direction that points away from the working substrate 509.

While three distinct methodologies have been described above, it will be appreciated that features of each of the described embodiments may be combined.

### Device Structures

Using the methodology as described herein it is possible to fabricate working semiconductor wafer structures which do not comprise highly dislocated strain-matching layers which are present in the native semiconductor growth wafer. As such, a working semiconductor wafer structure can be provided which comprises:
a working substrate; and
an active semiconductor layer structure bonded to the working substrate, and
wherein the working semiconductor wafer structure does not include a single crystal strain-matching layer structure disposed between the working substrate and the active semiconductor layer structure which has a thickness of at least 1 micrometer, 500 nm, 200 nm, 100 nm, 50 nm, 10 nm, or 1 nm and/or a concentration of dislocation defects of at least 1 x 10¹⁰ defects/cm², 1 x 10⁹ defects/cm², 1 x 10⁸ defects/cm², 1 x 10⁷ defects/cm², or 1 x 10⁶ defects/cm².

The single crystal strain-matching layer structure may comprise one more strain-matching layers. While the aforementioned definition envisages the removal of at least the most highly dislocated / thick strain-matching layers, preferably all the strain matching layers are removed such that the working semiconductor wafer structure does not include any single crystal strain-matching layers disposed between the working substrate and the active semiconductor layer structure.

Using the methodology as described herein it is also possible to fabricate working semiconductor wafer structures which have a low concentration of dislocation defects in the active semiconductor layer structure. For example, the active semiconductor layer structure may comprise a concentration of dislocation defects in a layer distal to the working substrate and/or in a layer proximal to the working substrate which is less than 1 x 10⁸ defects/cm², 5 x 10⁷ defects/cm², 1 x 10⁷ defects/cm², 5 x 10⁶ defects/cm², or less than 1 x 10⁶ defects/cm².

In relation to the above, it may be noted that various methods are known in the art for measuring dislocation defect density including transmission electron microscopy (TEM) and x-ray diffraction (XRD) techniques. One simple approach involves applying a revealing etch to a surface of a sample. The revealing etch preferentially etches the surface at dislocation defects resulting in the formation of etch pits, the number of etch pits corresponding to the number of dislocation defects. These etch pits can then simply be counted over a given area to measure the dislocation defect concentration per unit area. In this regard, it should be noted that a dislocation defect may comprise a bundle of individual dislocations as is known in the art.

The working semiconductor wafer structure may further comprise a functional layer disposed between the active semiconductor layer structure and the working substrate. In this case, if the functional layer is a single crystal layer, it can be distinguished over the single crystal strain matching layers of the native growth wafer in that it will not be so highly dislocated. For example, the functional layer may have a concentration of dislocation defects which is less than 1x10⁸ defects/cm², less than 5 x 10⁷ defects/cm², less than 1 x 10⁷ defects/cm², less than 5 x 10⁶ defects/cm², or less than 1 x 10⁶ defects/cm². That said, for many applications the functional layer will have an amorphous or polycrystalline structure and thus will be distinct from the single crystal strain matching layers of the native growth wafer. Alternatively, the functional layer may comprise at least one metal layer, e.g. to function as a mirror in a light emitting device structure.

Other examples of suitable functional layers include silicon nitride, aluminum nitride, and silicon carbide. These materials are particularly useful for bonding the active semiconductor layer structure to a working substrate which comprises synthetic diamond material. For example, such a working substrate may be bonded to the active semiconductor layer structure by depositing a layer of silicon nitride, aluminum nitride, or silicon carbide on an active semiconductor layer structure supported on a native or transfer substrate. A layer of polycrystalline CVD diamond may then be deposited thereon. A further support layer may be bonded to the layer of polycrystalline CVD diamond before removal of the native or transfer substrate.

The methodology as described herein is particularly useful for fabricating high power and/or high frequency devices which operate at high temperatures. Gallium nitride is a particularly useful semiconductor material for such applications. Accordingly, the active semiconductor layer structure may comprise at least one layer made out of gallium nitride and may further comprise at least one layer made out of indium gallium nitride or aluminium gallium nitride.

For most applications, the active semiconductor layer structure will comprise more than one active semiconductor layer. For example, the active semiconductor layer structure may comprise a semiconductive buffer layer (e.g. GaN) proximate to the working substrate and a semiconductive barrier layer (e.g. AlGaN) distal to the working substrate.

The working substrate may be formed of amorphous or polycrystalline material. Examples of materials for the working substrate include silicon carbide, aluminum nitride, sapphire, silicon, silicon nitride, diamond (e.g. chemical vapour deposited diamond), or combinations thereof.

### Reliability Studies

A reliability study on AlGaN/GaN high-electron mobility transistors fabricated on native silicon substrates (PRIOR ART) and with the AlGaN/GaN active layers transferred to a chemical-vapor deposited diamond substrates was performed. The layout and the active layered structure are identical for both devices. The difference between the two devices is that the AlGaN/GaN/silicon device is processed while the active layer is still on the native substrate, while AlGaN/GaN/Diamond device was built by transferring the AlGaN/GaN epilayers from the native substrate, removing the transition/nucleation/strain-matching layers, and attaching the epilayers to a new working substrate. The process to fabricate the semiconductor wafers on which the tested devices were fabricated included an anneal at approximately 700°C for 240 hours.

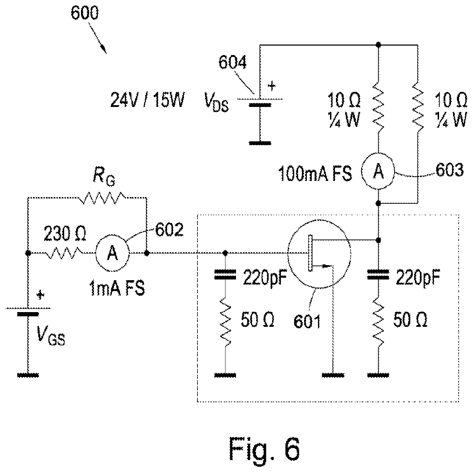

Figure 6 shows the circuit diagram 600 of the biasing and the measurements of a field-effect transistor under test 601. The drain is biased with a constant power supply 604 at 24 V while the gate is grounded. Drain current (IDSS) is continuously measured using an ammeter 603. The gate leakage current is monitored using another ammeter 602. The device is packaged and placed on a hotplate at an elevated temperature so that the channel reaches a temperature of 290°C by a combination of external and self-heating.

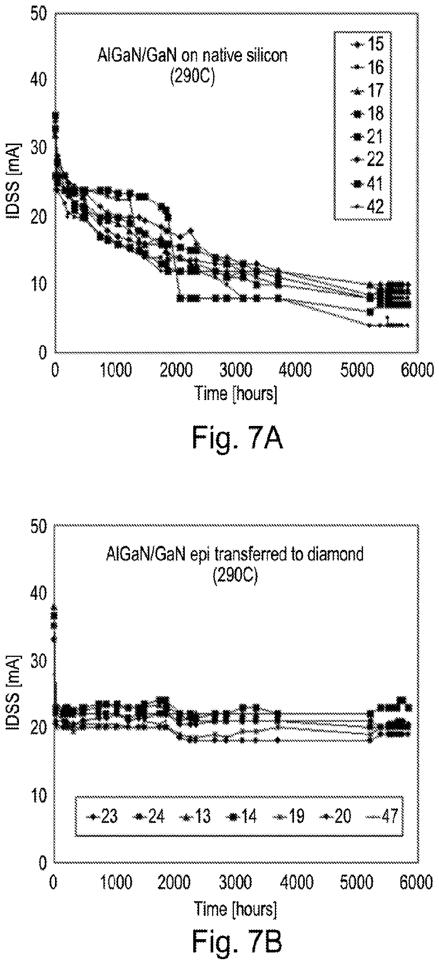

The IDSS measurements over time are shown in Figure 7 for both the GaN/Silicon (prior art) and GaN/Diamond devices. The first 10 hours of operation are considered to be burn in period showing fast drift in drain current for both types of devices. After the first 50 hours while the epilayers with the original transition/nucleation layers still in place continue to degrade, the epilayers with removed nucleation layers show significantly lower degradation in drain current. The data in Figure 7 shows clearly that the transferred epilayers which have the nucleation layers removed exhibit little degradation of drain current beyond the first 100 hours.

As the geometry and active layer structure was identical between the devices, the material quality is the primary agent affecting the reliability of the transistors. The dislocations present in the dislocated transition/nucleation layers move during the high-temperature stress and eventually degrade the field-effect transistor channel resulting in IDSS reduction.

In addition to the above described reliability study, further work has been performed as described below showing GaN-on-Diamond HEMTs operating continuously at channel temperatures of 290°C and 350°C for 9,000+ hrs and 3,000+ hrs respectively. No catastrophic failures were observed whereas all the control GaN-on-Si HEMTs exhibited catastrophic failures.

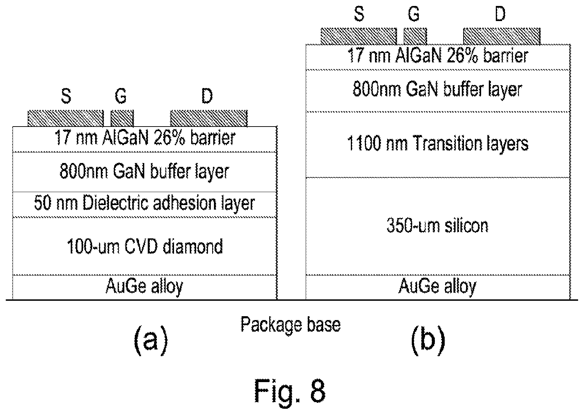

*Wafer Preparation* - In fabricating the GaN HEMTs that were tested here, GaN-on-Diamond wafers with epilayer structures shown in Figure 8 were prepared. The AlGaN/GaN HEMT layer structure was grown by metal-organic chemical vapor deposition (MOCVD) on a high resistivity Si (111) substrate by Nitronex Corporation (NC, USA). Epitaxial layers included, starting from the silicon substrate, a 1.1 µm thick transition buffer, an 800 nm thick undoped GaN buffer layer, a 17 nm thick Al_{0.26}Ga_{0.74}N Schottky barrier, and a 2 nm GaN cap layer. Electron mobility of 1400 cm²/V-s, sheet charge density of 9.6×10¹² cm⁻², and a sheet resistance of about 440 ohm/sq were measured for these wafers. The GaN epitaxial layers (GaN buffer, AlGaN barrier, and the GaN cap) were transferred to a 100 µm thick diamond wafer. The GaN epitaxy was transferred to diamond by first removing the host Si (111) and transition layers beneath the AlGaN/GaN epitaxy, depositing a 50 nm dielectric onto the exposed AlGaN/GaN, and finally growing a 100 µm thick CVD diamond layer onto the dielectric adhered to the epitaxial AlGaN/GaN films. In previously reported work the transition layers were preserved between the GaN and the diamond instead of being removed as they were in this experiment. Figure 8 shows the epilayer structure of the two types of devices tested in this work.

*Device Design* -The same device layout was used on both the GaN/Si and GaN-on-diamond devices. The gate metallization was Ni/Au, while silicon nitride was used for passivation. Target device physical dimensions were *Width W* = 2 × 200 µm, *Gate length L_{G}* = 1 µm, and *Gate-Drain Length L_{GD}* = 3 µm. The final chip size was 1.5 x 2 mm², and it contained six HEMTs per chip. The chips were packaged into Stratedge 580286 packages using AuGe eutectic alloy and two devices were wired to the external leads. The source terminal was connected to ground, while the gate and the drain terminals were brought to the package leads. The devices were stabilized inside the package by terminating each to ground through a series combination of a 50-Ω resistor and a 220-pF capacitor (also shown in Figure 6). The package lid was omitted. The devices were fabricated on 25-mm diameter GaN-on-Diamond wafers by OEPIC in Sunnyvale, CA.

*Device Test Setup* - In the life test, the *I_{DSS}* and the gate leakage *I_{GS}* that is drawn under *V_{DS}* = 24V supply voltage was monitored. The circuit diagram shown in Figure 6 shows the connections within and external to the package in the life-test system. There are two coil-and-magnet ammeters per device and the full-scale (FS) measurement range of the ammeters is extended by measuring the current in one of two branches whose current ratio is defined by parallel resistors.

The full-scale drain current reading of the drain-ammeter is doubled by using two 10-ohm resistors; the internal ammeter resistance is much less than one ohm. The gate ammeter has an internal resistance of 230 ohms and its current reading is increased approximately threefold by using the 100-ohm shunt resistor. The shunt resistors were not present on all of the devices - this depended on the starting value of *I_{DSS}*, but the current readings shown later were all scaled appropriately. Typical values of the I_{DSS} were GaN/Si - 130 mA, GaN-on-diamond ∼ 60 mA. Using a digital resistance meter, the orientation of mounted and wired devices was confirmed and the zero-bias channel resistance noted. The GaN/Si devices had *R*_{DS} ≈ 18 Ω, while GaN/Diamond had *R*_{DS} ≈ 24 Ω (both with the gate shorted to ground). The packaged devices were first split into two groups for tests at different temperatures and each group (containing some GaN/Si and some GaN-on-diamond devices) was mounted on a nickel plated copper plate, which was then attached to a temperature-controlled hotplate. Two hotplates were used. The thermal resistances of the GaN-on-diamond and GaN/Si devices were measured when the devices were packaged in the same package on a similar, but smaller nickel-plated copper plate yielding an average of ∼60°C/W for all devices. The value was not critical because self-heating contributed less than 10% of the total channel temperature rise.

The package leads were connected to the power supplies and ammeters via thin copper wire (lacquered transformer wire). The current readings were performed manually.

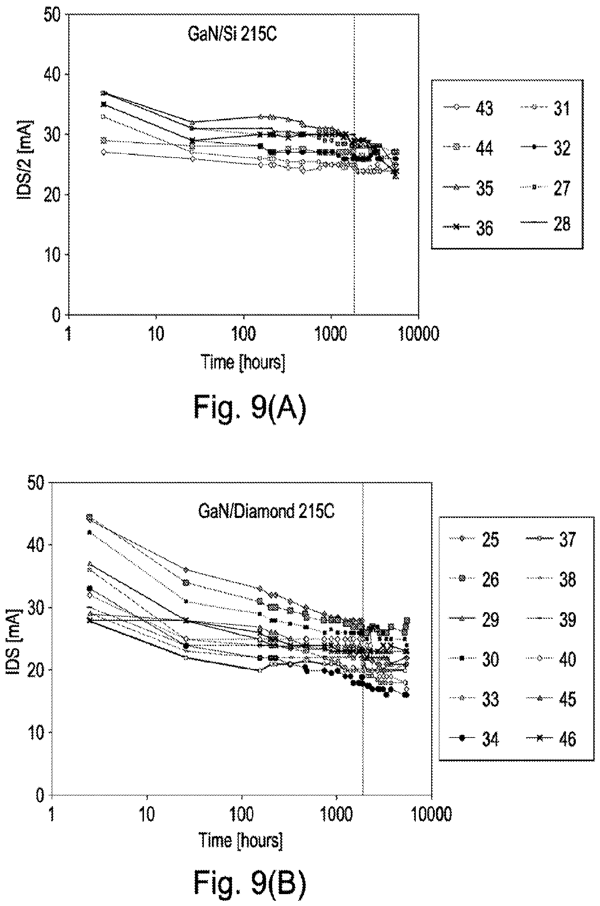

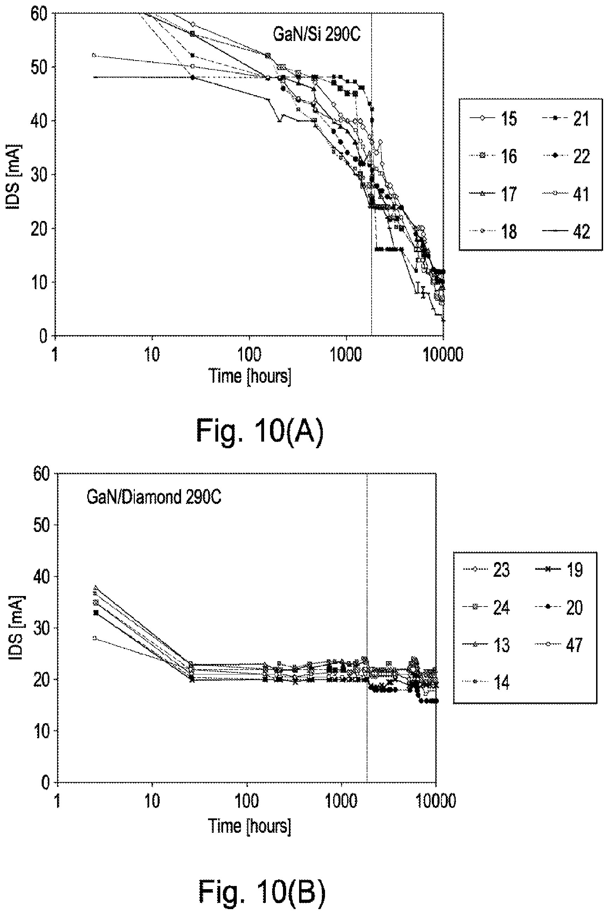

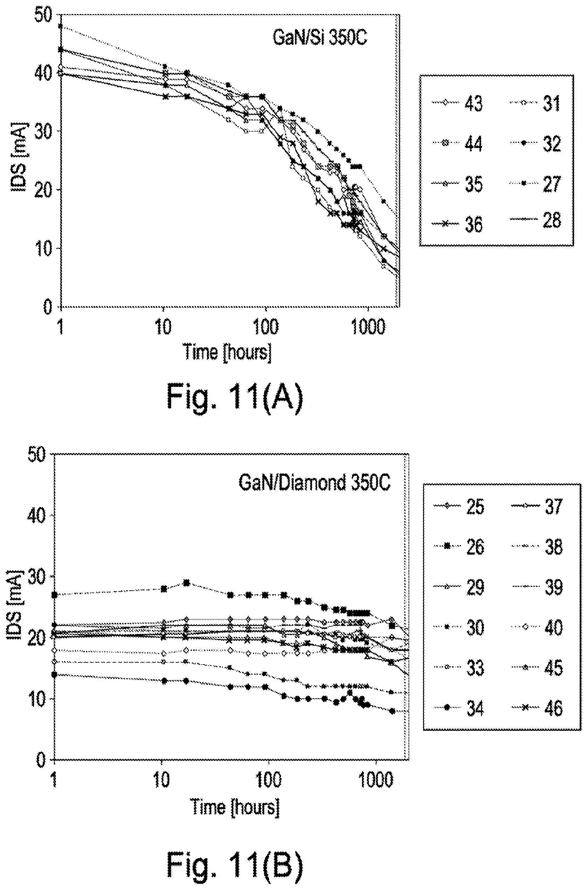

*Results* - The life test was performed in two phases: In the first phase (I), channel temperatures 215°C and 290°C were selected. During the first 5,000 hours, as shown in Figures 9A and 9B, it was observed that at 215°C, both GaN-on-diamond and GaN/Si devices degraded slowly with GaN-on-diamond devices degrading slightly faster than GaN/Si devices. At the same time, as shown in Figure 10A and 10B, at 290°C the opposite behavior was observed: after the initial burn-in period, GaN/Si devices degraded dramatically faster than the GaN-on-diamond devices whose *I_{DSS}* remained largely unchanged with time (during the first 5,000 hrs). In order to further examine this seemingly inconsistent behavior, the 215°C test (at 5,000Hrs) was interrupted and the temperature of hot plate raised to a channel temperature of 350°C. In this second phase, the channel temperatures of the two batches were 290°C (unchanged from before) and 350°C. Timing was initiated on the 350°C batch from zero. In this phase, it was observed that GaN/Si degraded dramatically at 350°C as was previously observed at 290°C (Figure 11A), and that GaN-on-diamond remained largely unchanged until around 1000 hours where the degradation in *I_{DSS}* appears to acquire a gradual downward slope (Figure 11B).

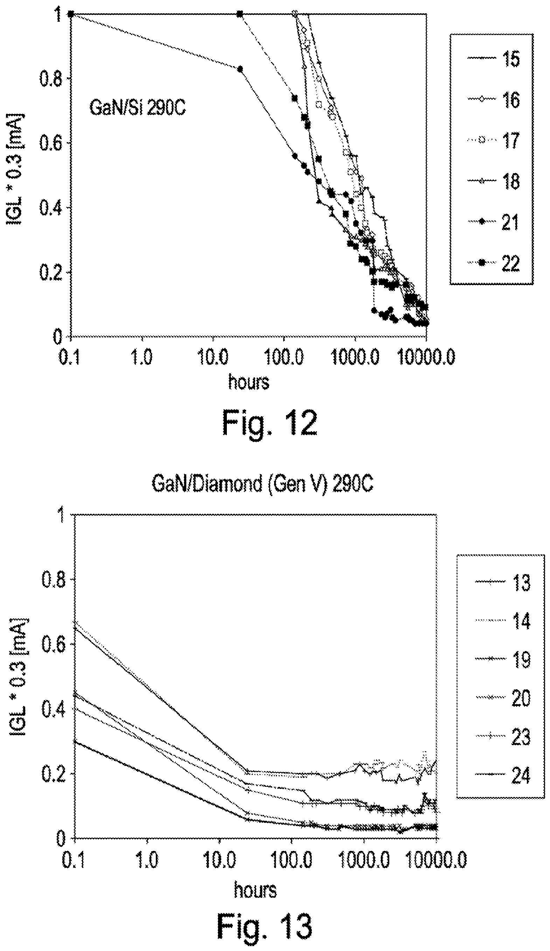

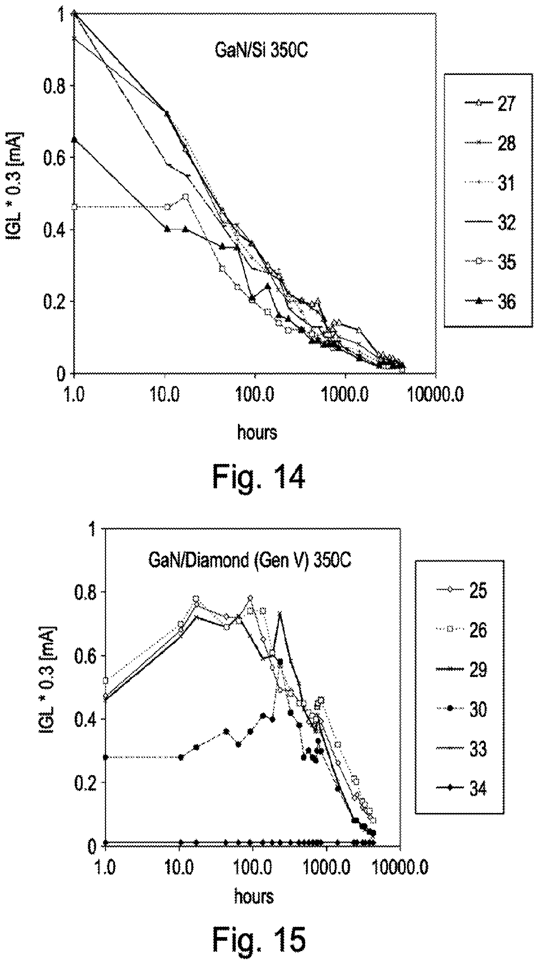

A key observation taken from these results was that after the first burn-in period (<100 hours), GaN-on-Diamond devices degrade significantly slower than their GaN/silicon counterparts of the same layout and similar device process. Furthermore, no catastrophic failures were observed on any of the GaN-on-Diamond devices. The vertical dashed lines in the life-test data in figures 9A, 9B, and 10A, and 10B indicate the time when the life-test systems were geographically relocated causing a slight shift in the measurements. The noise in the appearance of the data is attributed to the fact that the meters are analog and measured by the human eye; data can thus be subject to changes in the physical perspective of the observation. In Figures 12 to 15, the time dependence of the gate leakage currents is shown in all the aforementioned devices. In all cases, time and temperature appear to heal the leakage current. At 290°C, GaN-on-Diamond devices appear to heal faster (within 10hrs) than the GaN/Silicon (within several thousand hours). There is a clear resilience of GaN-on-diamond devices to high channel temperatures as compared to GaN/Silicon devices.

It has thus been shown that GaN-on-Diamond HEMT devices outlast GaN-on-Si in high-temperature operating life/endurance tests by thousands of hours - usually never failing; GaN-on-Si devices failed very shortly after start in almost all cases. The GaN epitaxy, device structure, and geometry are the same across all the devices. Temperatures of ∼ 215°C, 290°C, and 350°C were used for the test that spanned up to 10,000 hrs for many of the device batches. The performance improvements when compared to previous work are at least partially attributable to the removal of the strain-matching layers in the original native semiconductor growth substrates.

While this invention has been particularly shown and described with reference to embodiments, it will be understood by those skilled in the art that various changes in form and detail may be made without departing from the scope of the invention as defined by the appendant claims.

## Claims

1. A method of manufacturing a working semiconductor wafer structure for semiconductor device fabrication thereon, the method comprising:
starting with a native semiconductor growth wafer comprising:
a native growth substrate (301) having a first lattice constant *x*₁;
an active semiconductor layer structure (303) having a second lattice constant *x*₂
different from said first lattice constant *x*₁ by at least 1%; and
one or more single crystal strain-matching layers (302) disposed between the native
growth substrate and the active semiconductor layer structure;
transferring at least a portion of the active semiconductor layer structure to a working substrate (309); and
removing at least a portion of the one or more single crystal strain-matching layers of the native semiconductor,
whereby the working semiconductor wafer structure is formed and comprises the working substrate, at least a portion of the active semiconductor layer structure of the native semiconductor growth wafer, but does not include at least a portion of the one or more single crystal strain-matching layers of the native semiconductor growth wafer,
wherein the transferring and removing steps comprise:
attaching a transfer substrate to the active semiconductor layer structure of the native semiconductor growth wafer;
removing the native growth substrate;
removing the one or more single crystal strain-matching layers of the native semiconductor;
attaching the working substrate to the active semiconductor layer structure; and
removing the transfer substrate to form a working surface of the active semiconductor layer structure in the working semiconductor wafer structure, and
wherein the working substrate comprises polycrystalline diamond and the step of attaching the working substrate to the active semiconductor layer structure comprises depositing polycrystalline diamond over the active semiconductor layer structure using a chemical vapour deposition, CVD, technique after removing the one or more single crystal strain-matching layers of the native semiconductor.

2. A method according to claim 1,
wherein one or more of the single crystal strain-matching layers have a concentration of dislocation defects of at least 1x10⁶ defects/cm², 1 x 10⁷ defects/cm², 1 x 10⁸ defects/cm², 1 x 10⁹ defects/cm², or 1 x 10¹⁰ defects/cm².

3. A method according to any preceding claim,
further comprising removing a portion of the active semiconductor layer structure proximate to the strain-matching layer of the native semiconductor growth wafer after removing the one or more single crystal strain-matching layers, whereby the working semiconductor wafer structure only comprises a portion of the active semiconductor layer structure which was distal to the native growth substrate in the native semiconductor growth wafer.

4. A method according to any preceding claim,
wherein the transfer substrate is attached to the active semiconductor layer structure of the native semiconductor growth wafer via a protective layer disposed between the transfer substrate and the active semiconductor layer structure; and
after removing the transfer substrate the protective layer is also removed to reveal the working surface of the active semiconductor layer structure in the working semiconductor wafer structure.

5. A method according to claim 4,
wherein the protective layer is formed of at least one amorphous or polycrystalline material.

6. A method according to any preceding claim,
wherein the working substrate is attached to the active semiconductor layer structure via a functional layer disposed between the working substrate and the active semiconductor layer structure.

7. A method according to any preceding claim,
further comprising fabricating at least one electronic or optoelectronic device on the active semiconductor layer structure in the working semiconductor wafer structure.

8. A working semiconductor wafer structure comprising:
a working substrate comprising polycrystalline CVD diamond; and
an active semiconductor layer structure bonded to the working substrate,
wherein the working semiconductor wafer structure does not include a single crystal strain-matching layer structure disposed between the working substrate and the active semiconductor layer structure which has a concentration of dislocation defects of at least 1 x 10¹⁰ defects/cm².

9. A working semiconductor wafer structure according to claim 8,
wherein the working semiconductor wafer structure does not include a single crystal strain-matching layer structure disposed between the working substrate and the active semiconductor layer structure which has a concentration of dislocation defects of at least 1 x 10⁹ defects/cm², 1 x 10⁸ defects/cm², 1 x 10⁷ defects/cm², or 1 x 10⁶ defects/cm².

10. A working semiconductor wafer structure according to claim 8 or 9,
wherein the working semiconductor wafer structure does not include a single crystal strain-matching layer structure disposed between the working substrate and the active semiconductor layer structure which has a thickness of at least 1 micrometer, 500 nm, 200 nm, 100 nm, 50 nm, 10 nm, or 1 nm.

11. A working semiconductor wafer structure according to any of claims 8 to 10,
wherein the working semiconductor wafer structure does not include any single crystal strain-matching layers disposed between the working substrate and the active semiconductor layer structure.

12. A working semiconductor wafer structure according to any of claims 8 to 11,
wherein the active semiconductor layer structure comprises a concentration of dislocation defects in a layer distal to the working substrate and/or in a layer proximal to the working substrate which is less than 1 x 10⁸ defects/cm², 5 x 10⁷ defects/cm², 1 x 10⁷ defects/cm², 5 x 10⁶ defects/cm², or 1 x 10⁶ defects/cm².

13. A working semiconductor wafer structure according to any of claims 8 to 12,
further comprising a functional layer disposed between the active semiconductor layer structure and the working substrate, wherein the functional layer has an amorphous or polycrystalline structure.

14. A working semiconductor wafer structure according to claim 13,
wherein the functional layer is selected from a group consisting of silicon nitride, aluminum nitride, and silicon carbide.

15. A working semiconductor wafer structure according to any of claims 8 to 14,
wherein the active semiconductor layer structure comprises a semiconductive buffer layer proximate to the working substrate and a semiconductive barrier layer distal to the working substrate and wherein the active semiconductor layer structure comprises at least one layer made out of gallium nitride.

## Patentansprüche

1. Verfahren zur Herstellung einer Halbleiterscheiben-Arbeitsstruktur, um darauf Halbleiterbauelemente herzustellen, wobei das Verfahren umfasst:
mit einem nativen Halbleiter-Wachstumswafer beginnen, der Folgendes umfasst:
ein natives Wachstumssubstrat (301) mit einer ersten Gitterkonstante *x*₁;
eine aktive Halbleiterschichtstruktur (303) mit einer zweiten Gitterkonstante *x*₂, die sich von der ersten Gitterkonstante *x*₁ um mindestens 1% unterscheidet; und
eine oder mehrere monokristalline Anpassungsschichten mit gleicher Gitterspannung (302), die zwischen dem nativen Wachstumssubstrat und der aktiven Halbleiterschichtenstruktur angeordnet sind;
mindestens einen Teil der aktiven Halbleiterschichtstruktur auf ein Arbeitssubstrat (309) übertragen; und
mindestens einen Teil der einen oder mehreren monokristallinen Anpassungsschichten mit gleicher Gitterspannung des nativen Halbleiters entfernen,
wobei die Halbleiterscheiben-Arbeitsstruktur gebildet wird und das Arbeitssubstrat und zumindest einen Teil der aktiven Halbleiterschichtstruktur des nativen Halbleiter-Wachstumswafers umfasst, jedoch nicht zumindest einen Teil der einen oder mehreren monokristallinen Anpassungsschichten mit gleicher Gitterspannung des nativen Halbleiter-Wachstumswafers,
wobei die Schritte der Übertragung und Entfernung umfassen:
ein Transfersubstrat an der aktiven Halbleiterschichtstruktur des nativen Halbleiter-Wachstumswafers anbringen;
das native Wachstumssubstrat entfernen;
die eine oder die mehreren monokristallinen Anpassungsschichten mit gleicher Gitterspannung des nativen Halbleiters entfernen;
das Arbeitssubstrat an der aktiven Halbleiterschichtstruktur anbringen;
das Transfersubstrat entfernen, um in der Halbleiterscheiben-Arbeitsstruktur eine Arbeitsfläche der aktiven Halbleiterschichtstruktur zu bilden und
wobei das Arbeitssubstrat einen polykristallinen Diamant umfasst und der Schritt, das Arbeitssubstrat an der aktiven Halbleiterschichtstruktur anbringen umfasst, den polykristallinen Diamant über der aktiven Halbleiterschichtstruktur unter Verwendung einer chemischen Gasphasenabscheidung (Chemical-Vapour-Deposition-Verfahren bzw. CVD-Verfahren) abzuscheiden, nachdem die eine oder die mehreren monokristallinen Anpassungsschichten mit gleicher Gitterspannung des nativen Halbleiters entfernt wurden.

2. Verfahren gemäß Anspruch 1, ferner umfassend:
wobei eine oder mehrere monokristalline Anpassungsschichten mit gleicher Gitterspannung eine Versetzungsfehler-Konzentration von mindestens 1 x 10⁶ Defekte/cm², 1 x 10⁷ Defekte/cm², 1 x 10⁸ Defekte/cm², 1 x 10⁹ Defekte/cm² oder 1 x 10¹⁰ Defekte/cm² aufweisen.

3. Verfahren gemäß einem der vorhergehenden Ansprüche,
ferner umfassend, einen Teil der aktiven Halbleiterschichtstruktur in der Nähe der Anpassungsschicht mit gleicher Gitterspannung des nativen Halbleiter-Wachstumswafers entfernen, nachdem die eine oder die mehreren monokristallinen Anpassungsschichten mit gleicher Gitterspannung entfernt wurden, wobei die Halbleiterscheiben-Arbeitsstruktur nur einen Teil der aktiven Halbleiterschichtstruktur umfasst, die im nativen Halbleiter-Wachstumswafer fern vom nativen Wachstumssubstrat war.

4. Verfahren gemäß einem der vorhergehenden Ansprüche,
wobei ein Transfersubstrat an der aktiven Halbleiterschichtstruktur des nativen Halbleiter-Wachstumswafers über eine Schutzschicht angebracht ist, die zwischen dem Transfersubstrat und der aktiven Halbleiterschichtenstruktur angeordnet ist;
nachdem das Transfersubstrat entfernt wurde, wird auch die Schutzschicht entfernt, um die Arbeitsfläche der aktiven Halbleiterschichtstruktur in der Halbleiterscheiben-Arbeitsstruktur freizulegen.

5. Verfahren gemäß Anspruch 4,
wobei die Schutzschicht aus mindestens einem amorphen oder polykristallinen Material gebildet ist.

6. Verfahren gemäß einem der vorhergehenden Ansprüche,
wobei das Arbeitssubstrat an der aktiven Halbleiterschichtstruktur über eine Funktionsschicht angebracht ist, die zwischen dem Arbeitssubstrat und der aktiven Halbleiterschichtenstruktur angeordnet ist;

7. Verfahren gemäß einem der vorhergehenden Ansprüche,
ferner umfassend mindestens ein elektronisches oder optoelektronisches Bauelement auf der aktiven Halbleiterschichtenstruktur in der Halbleiterscheiben-Arbeitsstruktur herstellen.

8. Halbleiterscheiben-Arbeitsstruktur umfassend:
ein Arbeitssubstrat, umfassend einen polykristallinen CVD-Diamant; und
eine an das Arbeitssubstrat gebundene aktive Halbleiterschichtstruktur,
wobei die Halbleiterscheiben-Arbeitsstruktur keine monokristalline Anpassungsschichtstruktur mit gleicher Gitterspannung umfasst, die zwischen dem Arbeitssubstrat und der aktiven Halbleiterschichtstruktur angeordnet ist und eine Versetzungsfehler-Konzentration von mindestens 1 x 10¹⁰ Defekte/cm² aufweist.

9. Halbleiterscheiben-Arbeitsstruktur gemäß Anspruch 8,
wobei die Halbleiterscheiben-Arbeitsstruktur keine monokristalline Anpassungsschichtstruktur mit gleicher Gitterspannung umfasst, die zwischen dem Arbeitssubstrat und der aktiven Halbleiterschichtstruktur angeordnet ist und eine Versetzungsfehler-Konzentration von mindestens 1 x 10⁹ Defekte/cm², 1 x 10⁸ Defekte/cm², 1 x 10⁷ Defekte/cm² oder 1 x 10⁶ Defekte/cm² aufweist.

10. Halbleiterscheiben-Arbeitsstruktur gemäß Anspruch 8 oder 9,
wobei die Halbleiterscheiben-Arbeitsstruktur keine monokristalline Anpassungsschichtstruktur mit gleicher Gitterspannung umfasst, die zwischen dem Arbeitssubstrat und der aktiven Halbleiterschichtstruktur angeordnet ist und eine Dicke von mindestens 1 Mikrometer, 500 nm, 200 nm, 100 nm, 50 nm, 10 nm oder 1 nm aufweist.

11. Halbleiterscheiben-Arbeitsstruktur gemäß einem der Ansprüche 8 bis 10,
wobei die Halbleiterscheiben-Arbeitsstruktur keine monokristalline Anpassungsschichten mit gleicher Gitterspannung umfasst, die zwischen dem Arbeitssubstrat und der aktiven Halbleiterschichtstruktur angeordnet sind.

12. Halbleiterscheiben-Arbeitsstruktur gemäß einem der Ansprüche 8 bis 11,
wobei die aktive Halbleiterschichtstruktur in einer dem Arbeitssubstrat entfernten Schicht und/oder in einer dem Arbeitssubstrat nahen Schicht eine Versetzungsfehler-Konzentration aufweist, die unter 1 x 10⁸ Defekte/cm², 5 x 10⁷ Defekte/cm², 1 x 10⁷ Defekte/cm², 5 x 10⁶ Defekte/cm² oder 1 x 10⁶ Defekte/cm² liegt.

13. Halbleiterscheiben-Arbeitsstruktur gemäß einem der Ansprüche 8 bis 12,
ferner umfassend eine zwischen der aktiven Halbleiterschichtstruktur und dem Arbeitssubstrat angeordnete Funktionsschicht, wobei die Funktionsschicht eine amorphe oder polykristalline Struktur aufweist.

14. Halbleiterscheiben-Arbeitsstruktur gemäß Anspruch 13,
wobei die Funktionsschicht ausgewählt ist aus einer Gruppe bestehend aus Siliziumnitrid, Aluminiumnitrid und Siliziumcarbid.

15. Halbleiterscheiben-Arbeitsstruktur gemäß einem der Ansprüche 8 bis 14,
wobei die aktive Halbleiterschichtstruktur in der Nähe des Arbeitssubstrats eine halbleitende Pufferschicht und fern vom Arbeitssubstrat eine halbleitende Sperrschicht umfasst und wobei die aktive Halbleiterschichtstruktur mindestens eine Schicht aus Galliumnitrid umfasst.

## Revendications

1. Un procédé de fabrication d'une structure de plaquette de semi-conducteur actif pour la fabrication de dispositif semi-conducteur sur celle-ci, le procédé comprenant :
en commençant par une plaquette de croissance de semi-conducteur natif comprenant :
un substrat de croissance natif (301) ayant une première constante de réseau *x*₁ ;
une structure de couche de semi-conducteur actif (303) ayant une deuxième constante de réseau *x*₂ différente de ladite première constante de réseau *x*₁ d'au moins 1 % ; et
une ou plusieurs couches monocristallines d'adaptation de contraintes (302) disposées entre le substrat de croissance natif et la structure de couche de semi-conducteur actif ;
le transfert d'au moins une partie de la structure de couche de semi-conducteur actif vers un substrat actif (309) ; et
le retrait d'au moins une partie de la ou des plusieurs couches monocristallines d'adaptation de contraintes du semi-conducteur natif,
par lequel la structure de plaquette de semi-conducteur actif est formée et comprend le substrat actif, au moins une partie de la structure de couche de semi-conducteur actif de la plaquette de croissance de semi-conducteur natif, mais ne comprend pas au moins une partie de la ou des plusieurs couches monocristallines d'adaptation de contraintes de la plaquette de croissance de semi-conducteur natif,
dans lequel les étapes de transfert et de retrait comprennent :
la fixation d'un substrat de transfert à la structure de couche de semi-conducteur actif de la plaquette de croissance de semi-conducteur natif ;
le retrait du substrat de croissance natif ;
le retrait de la ou des plusieurs couches monocristallines d'adaptation de contraintes du semi-conducteur natif ;
la fixation du substrat actif à la structure de couche de semi-conducteur actif ; et
le retrait du substrat de transfert pour former une surface active de la structure de couche de semi-conducteur actif dans la structure de plaquette de semi-conducteur actif, et
dans lequel le substrat actif comprend du diamant polycristallin et l'étape de fixation du substrat actif à la structure de couche de semi-conducteur actif comprend le dépôt de diamant polycristallin sur la structure de couche de semi-conducteur actif en utilisant une technique de dépôt chimique en phase vapeur, CVD, après le retrait de la ou des plusieurs couches monocristallines d'adaptation de contraintes du semi-conducteur natif.

2. Un procédé selon la revendication 1,
dans lequel une ou plusieurs des couches monocristallines d'adaptation de contraintes ont une concentration de défauts de dislocation d'au moins 1 x 10⁶ défauts/cm², 1 x 10⁷ défauts/cm², 1 x 10⁸ défauts/cm², 1 x 10⁹ défauts/cm², ou 1 x 10¹⁰ défauts/cm².

3. Un procédé selon l'une quelconque des revendications précédentes,
comprenant en outre le retrait d'une partie de la structure de couche de semi-conducteur actif proche de la couche d'adaptation de contraintes de la plaquette de croissance de semi-conducteur natif après le retrait de la ou des plusieurs couches monocristallines d'adaptation de contraintes, par lequel la structure de plaquette de semi-conducteur actif ne comprend qu'une partie de la structure de couche de semi-conducteur actif qui était distale par rapport au substrat de croissance natif dans la plaquette de croissance de semi-conducteur natif.

4. Un procédé selon l'une quelconque des revendications précédentes,
dans lequel le substrat de transfert est fixé à la structure de couche de semi-conducteur actif de la plaquette de croissance de semi-conducteur natif via une couche protectrice disposée entre le substrat de transfert et la structure de couche de semi-conducteur actif ; et
après le retrait du substrat de transfert, la couche protectrice est également retirée pour révéler la surface active de la structure de couche de semi-conducteur actif dans la structure de plaquette de semi-conducteur actif.

5. Un procédé selon la revendication 4,
dans lequel la couche protectrice est formée d'au moins un matériau amorphe ou polycristallin.

6. Un procédé selon l'une quelconque des revendications précédentes,
dans lequel le substrat actif est fixé à la structure de couche de semi-conducteur actif via une couche fonctionnelle disposée entre le substrat actif et la structure de couche de semi-conducteur actif.

7. Un procédé selon l'une quelconque des revendications précédentes,
comprenant en outre la fabrication d'au moins un dispositif électronique ou optoélectronique sur la structure de couche de semi-conducteur actif dans la structure de plaquette de semi-conducteur actif.

8. Une structure de plaquette de semi-conducteur actif comprenant :
un substrat actif comprenant du diamant CVD polycristallin ; et
une structure de couche de semi-conducteur actif liée au substrat actif,
dans laquelle la structure de plaquette de semi-conducteur actif ne comprend pas de structure de couche monocristalline d'adaptation de contraintes disposée entre le substrat actif et la structure de couche de semi-conducteur actif qui a une concentration de défauts de dislocation d'au moins 1 x 10¹⁰ défauts/cm².

9. Une structure de plaquette de semi-conducteur actif selon la revendication 8,
dans laquelle la structure de plaquette de semi-conducteur actif ne comprend pas de structure de couche monocristalline d'adaptation de contraintes disposée entre le substrat actif et la structure de couche de semi-conducteur actif qui a une concentration de défauts de dislocation d'au moins 1 x 10⁹ défauts/cm², 1 x 10⁸ défauts/cm², 1 x 10⁷ défauts/cm², ou 1 x 10⁶ défauts/cm².

10. Une structure de plaquette de semi-conducteur actif selon la revendication 8 ou 9,
dans laquelle la structure de plaquette de semi-conducteur actif ne comprend pas de structure de couche monocristalline d'adaptation de contraintes disposée entre le substrat actif et la structure de couche de semi-conducteur actif qui a une épaisseur d'au moins 1 micromètre, 500 nm, 200 nm, 100 nm, 50 nm, 10 nm, ou 1 nm.

11. Une structure de plaquette de semi-conducteur actif selon l'une quelconque des revendications 8 à 10,
dans laquelle la structure de plaquette de semi-conducteur actif ne comprend aucune couche monocristalline d'adaptation de contraintes disposée entre le substrat actif et la structure de couche de semi-conducteur actif.

12. Une structure de plaquette de semi-conducteur actif selon l'une quelconque des revendications 8 à 11,
dans laquelle la structure de couche de semi-conducteur actif comprend une concentration de défauts de dislocation dans une couche distale par rapport au substrat actif et / ou dans une couche proximale par rapport au substrat actif qui est inférieure à 1 x 10⁸ défauts/cm², 5 x 10⁷ défauts/cm², 1 x 10⁷ défauts/cm², 5 x 10⁶ défauts/cm², ou 1 x 10⁶ défauts/cm².

13. Une structure de plaquette de semi-conducteur actif selon l'une quelconque des revendications 8 à 12,
comprenant en outre une couche fonctionnelle disposée entre la structure de couche de semi-conducteur actif et le substrat actif, dans laquelle la couche fonctionnelle a une structure amorphe ou polycristalline.

14. Une structure de plaquette de semi-conducteur actif selon la revendication 13,
dans laquelle la couche fonctionnelle est choisie dans un groupe constitué par le nitrure de silicium, le nitrure d'aluminium, et le carbure de silicium.

15. Une structure de plaquette de semi-conducteur actif selon l'une quelconque des revendications 8 à 14,
dans laquelle la structure de couche de semi-conducteur actif comprend une couche tampon semi-conductrice proche du substrat actif et une couche barrière semi-conductrice distale par rapport au substrat actif et dans laquelle la structure de couche de semi-conducteur actif comprend au moins une couche faite de nitrure de gallium.
